# EUROPEAN PATENT APPLICATION

(11) **EP 4 674 636 A1**
(43) Date of publication of application: **07.01.2026**
(21) Application number: 24763604.6
(22) Date of filing: 14.02.2024
(51) Int. Cl.: B41N 1/14, B41C 1/00, B41C 1/10, G03F 7/00, G03F 7/11

(54) **DIRECT-DRAWING-TYPE WATERLESS LITHOGRAPHIC PRINTING PLATE PRECURSOR AND METHOD FOR PRODUCING WATERLESS LITHOGRAPHIC PRINTING PLATE THEREFROM**

(30) Priority: 27.02.2023 JP 2023028022; 14.11.2023 JP 2023193350
(71) Applicant: Toray Industries, Inc., Tokyo 103-8666 (JP)
(72) Inventor: IIHARA, Akihiro, Otsu-shi, Shiga 520-8558 (JP); KUSE, Yasunori, Otsu-shi, Shiga 520-8558 (JP)
(74) Representative: Mewburn Ellis LLP
(86) International application number: PCT/JP2024/004954
(87) International publication number: WO 2024/181121

(57) **Abstract**

Disclosed is a directly imageable waterless planographic printing plate precursor comprising a primer layer, a heat sensitive layer and a silicone rubber layer on a substrate in this order, wherein, within a 750 µm-wide region of the primer layer in the cross-section, the sum of the total area of portions protruding from a reference height of the primer layer and the total area of portions recessing from a reference height of the primer layer is 0 to 60 µm². The present invention provides a directly drawn waterless planographic printing plate precursor capable of obtaining a waterless planographic printing plate having satisfactory image reproducibility and printing durability in large-sized plates and little printing unevenness.

## Description

### TECHNICAL FIELD

The present invention relates to a directly imageable waterless planographic printing plate precursor, and a method for producing a waterless planographic printing plate using the same.

### BACKGROUND ART

There are various printing methods such as letterpress printing, intaglio printing, stencil (screen) printing, planographic printing and inkjet printing methods, and printing is carried out by taking advantage of the characteristics of each method. Of these, planographic printing method is advantageous compared with other printing methods in that high-resolution printed matter can be obtained. Printing plates used for planographic printing (hereinafter referred to as planographic printing plates) are broadly classified into water-wet planographic printing plates in which the non-image areas are made ink-repellent by the action of a dampening solution, and waterless planographic printing plates in which a silicone rubber or a fluororesin is used for the ink-repellent non-image areas without using the dampening solution.

Various proposals have been made so far regarding techniques for obtaining waterless planographic printing plates using a silicone rubber as the ink-repellent nonprinting areas. For example, there have been proposed a directly imageable waterless planographic printing plate precursor comprising a crosslinked polymeric image layer and an oleophobic top layer on a metal plate having a roughened surface in this order (see, for example, Patent Document 1), and a directly imageable waterless planographic printing plate precursor comprising at least a heat insulating layer, a heat sensitive layer and a silicone rubber layer on a substrate in this order (see, for example, Patent Document 2).

### PRIOR ART DOCUMENTS

### PATENT DOCUMENTS

Patent Document 1: US 10,011,137
Patent Document 2: JP 2004-334025 A

### SUMMARY OF THE INVENTION

### PROBLEMS TO BE SOLVED BY THE INVENTION

In recent years, planographic printing has been used for printing on flexible packaging, decorative printing for building materials and the like, and there is a trend for large-sized printed matter to be required for these applications. For this reason, there is a demand for large-sized waterless planographic printing plates to have improved image reproducibility, suppressed printing unevenness and improved printing durability.

In the directly imageable waterless planographic printing plate precursor mentioned in Patent Document 1, a crosslinked polymeric image layer is thermally ablated by irradiation with a near-infrared laser, and a waterless planographic printing plate can be obtained by removing the thermally ablated crosslinked polymeric image layer and the oleophobic top layer thereon by a subsequent development treatment. However, since the metal plate surface is roughened, the crosslinked polymeric image layer provided on protruding portions of the metal plate surface is likely to become thinner and the heat generation efficiency of the crosslinked polymeric image layer in the thinned portions decreases, thus causing such a problem that image reproducibility tends to deteriorate in the thinned portions and therefore printing unevenness is likely to occur. Protrusions and depressions due to the roughening of the metal plate surface are likely to form on the surface of the crosslinked polymeric image layer, and stress is concentrated in the protruding portions during printing, and thus the silicone rubber layer located on the top of the protruding portions is likely to be damaged and there was also a problem with printing durability.

The directly imageable waterless planographic printing plate precursor mentioned in Patent Document 2 is capable of obtaining a waterless planographic printing plate by forming a latent image on top of a heat sensitive layer by irradiation with a near infrared laser and removing the silicone rubber layer corresponding to the image area of the latent image by a subsequent development treatment. Compared with Patent Document 1, since the substrate has low surface roughness and a heat insulating layer is provided between the substrate and the heat sensitive layer, the thickness of the heat sensitive layer is likely to be uniform, leading to the suppression of deterioration of image reproducibility and printing durability, and printing unevenness. However, since all the heat insulating layer solutions specifically exemplified in Patent Document 2 have high solid component concentration and high viscosity, thin film portions and protruding portions tend to be formed in the heat sensitive layer of the large-sized directly imageable waterless planographic printing plate precursors, and there was a demand for further improvement in image reproducibility and printing durability, as well as further suppression of printing unevenness.

Thus, the problem to be solved by the present invention is to provide a directly drawn waterless planographic printing plate precursor capable of obtaining a waterless planographic printing plate having satisfactory image reproducibility and printing durability in large-sized plates and little printing unevenness.

### SOLUTIONS TO THE PROBLEMS

In order to solve the above problems, the present invention mainly has the following configuration.
(1) A directly imageable waterless planographic printing plate precursor comprising a primer layer, a heat sensitive layer and a silicone rubber layer on a substrate in this order, wherein, within a 750 µm-wide region of the primer layer in the cross-section, the sum of the total area of portions protruding from a reference height of the primer layer and the total area of portions recessing from a reference height of the primer layer is 0 to 60 µm².
(2) The directly imageable waterless planographic printing plate precursor according to (1), wherein, within a 750 µm-wide region of the primer layer in the cross-section, the number of intersections between a reference height of the primer layer and a line representing an interface between the primer layer and the heat sensitive layer is 0 to 600.
(3) A directly imageable waterless planographic printing plate precursor comprising a primer layer, a heat sensitive layer and a silicone rubber layer on a substrate in this order, wherein a maximum peak height on the surface of the primer layer is 0.5 µm or less.
(4) he directly imageable waterless planographic printing plate precursor according to any one of (1) to (3), wherein the thinnest portion of the heat sensitive layer has a thickness of 0.2 µm or more.
(5) The directly imageable waterless planographic printing plate precursor according to any one of (1) to (4), wherein the thinnest portion of the primer layer has a thickness of 1 µm or more.
(6) The directly imageable waterless planographic printing plate precursor according to any one of (1) to (5), wherein, within a 750 µm-wide region of the heat sensitive layer in the cross-section, the sum of the total area of portions protruding from a reference height of the heat sensitive layer and the total area of portions recessing from a reference height of the heat sensitive layer is 0 to 30 µm².
(7) The directly imageable waterless planographic printing plate precursor according to any one of (1) to (6), wherein the primer layer has an average thickness of 2 to 500 µm.
(8) The directly imageable waterless planographic printing plate precursor according to any one of (1) to (7), wherein the heat sensitive layer has an average thickness of 0.5 to 2 µm.
(9) The directly imageable waterless planographic printing plate precursor according to any one of (1) to (8), wherein the silicone rubber layer has an average thickness of 3.2 to 4.8 µm.
(10) The directly imageable waterless planographic printing plate precursor according to any one of (1) to (9), wherein the heat sensitive layer is thermally-ablatable.
(11) The directly imageable waterless planographic printing plate precursor according to any one of (1) to (10), wherein the silicone rubber layer contains hard domains.
(12) The directly imageable waterless planographic printing plate precursor according to any one of (1) to (11), wherein, within a 750 µm-wide region of the substrate in the cross-section, the sum of the total area of portions protruding from a reference height of the substrate and the total area of portions recessing from a reference height of the substrate is 0 to 300 µm².
(13) A method for producing the waterless planographic printing plate, which comprises an exposure step of irradiating the directly imageable waterless planographic printing plate precursor according to any one of (1) to (12) with laser light to form a latent image; and a development step of removing the silicone rubber layer corresponding to an image area of the latent image.
(14) The method for producing a waterless planographic printing plate according to (13), wherein, in the exposure step of forming the latent image, an AM screen having a precision equivalent to an AM screen of 180 lpi to 650 lpi or an AM/FM mixed screen is used.

### EFFECTS OF THE INVENTION

The directly imageable waterless planographic printing plate precursor of the present invention is capable of obtaining a waterless planographic printing plate having satisfactory image reproducibility and printing durability in large-sized plates and little printing unevenness.

### BRIEF DESCRIPTION OF THE DRAWINGS

FIG. 1 is a cross-sectional schematic diagram showing a relationship between a reference height of a substrate and the substrate in an example of a conventionally known directly imageable waterless planographic printing plate precursor.
FIG. 2 is a cross-sectional schematic diagram of an example of a conventionally known directly imageable waterless planographic printing plate precursor.
FIG. 3 is a cross-sectional schematic diagram of an example of a directly imageable waterless planographic printing plate precursor of the present invention.
FIG. 4 is a cross-sectional schematic diagram showing a relationship between a reference height of a primer layer and the primer layer in an example of a conventionally known directly imageable waterless planographic printing plate precursor.
FIG. 5 is a cross-sectional schematic diagram showing an intersection between a reference height of a primer layer and a line representing an interface between the primer layer and a heat sensitive layer in an example of a conventionally known directly imageable waterless planographic printing plate precursor.
FIG. 6 is a cross-sectional schematic diagram showing a relationship between a reference height of a heat sensitive layer and the heat sensitive layer in an example of a conventionally known directly imageable waterless planographic printing plate precursor.

### EMBODIMENTS OF THE INVENTION

A directly imageable waterless planographic printing plate precursor (hereinafter sometimes abbreviated to "printing plate precursor") is a precursor before forming ink-receptive area/ink-repellent area are on a waterless planographic printing plate (hereinafter sometimes abbreviated to "printing plate"). The directly imageable waterless planographic printing plate precursor according to the present invention comprises a primer layer, a heat sensitive layer and a silicone rubber layer on a substrate in this order. The substrate has the function of maintaining the shape of the printing plate precursor or the printing plate. The primer layer has the functions of suppressing the influence of protrusions and depressions on the surface of the substrate, bonding the substrate and the heat sensitive layer, and providing heat insulation. The heat sensitive layer has the functions of forming a latent image by the heat generated by absorbing laser light, and forming an image area where ink adheres on the printing plate. However, if the heat sensitive layer is of thermally-ablatable mentioned below, the heat sensitive layer ablated by the heat generated by absorbing laser light is removed during the plate-making process, and the ink adheres on the surface of the primer layer rather than on the heat sensitive layer in the printing plate. The silicone rubber layer has the function of repelling ink, and forms the non-image areas on the printing plate. A directly imageable planographic printing plate precursor refers to a planographic printing plate precursor capable of directly writing from a manuscript using laser light, and a latent image can be formed by exposure without the need for a separate original film.

First, the substrate will be described.

The substrate is preferably made of dimensionally stable materials such as metal or plastic. Specific examples thereof include metals such as aluminum, iron, zinc and copper, and alloys containing these metals as the main component; plastics such as epoxy resins, phenolic resins, ester resins, vinyl ester resins, amide resins and imide resins; and fiber-reinforced plastics containing these plastics and fibers such as glass fibers, carbon fibers, aramid fibers, polyethylene fibers, Zylon fibers and boron fibers. Aluminum alloys and fiber reinforced plastics are preferable because they are lightweight, easy to handle, and have excellent printing durability.

The shape of the substrate may be, for example, a plate, a roll, a cylinder, a columnar shape or the like. When using a cylindrical or columnar substrate, it is possible to obtain a seamless waterless planographic printing plate precursor capable of printing continuous patterns. The shape of the substrate for the seamless waterless planographic printing plate precursor is preferably cylindrical, since it is lighter and easier to handle. The cylindrical substrate is preferably a plate cylinder of a printing machine, since printing can be carried out immediately after producing the printing plate from the printing plate precursor. In particular, it is more preferable that the cylindrical substrate is a plate cylinder sleeve that can be detached from the plate cylinder shaft of a printing machine, since the series of processes up to the production of a seamless waterless planographic printing plate and operations such as regenerating the substrate after printing can be carried out outside the printing machine.

When the substrate is in the form of a plate, the dimensions of the substrate may be selected to be appropriate for the printing press to be used (length, width, thickness, etc.). When the substrate is cylindrical, the diameter and width may be selected to be appropriate for the plate cylinder of the printing press to be used.

The roughness of the substrate surface is preferably 0.4 µm or less in terms of arithmetic mean roughness (Ra). By adjusting Ra of the substrate surface to 0.4 µm or less, the surface of the primer layer is easily smoothed, and image reproducibility and printing durability are further improved, and thus the printing unevenness can be further suppressed. Ra is more preferably 0.3 µm or less, and still more preferably 0.2 µm or less. Meanwhile, when Ra of the substrate surface is 0.04 µm or more, it is possible to produce the substrate only by rolling without performing a polishing treatment, and therefore, from the viewpoint of improving the productivity of the substrate, Ra of the substrate surface is preferably 0.04 µm or more. As mentioned above, conventional printing plate precursors had a problem that roughening the substrate surface tends to cause deterioration of the image reproducibility and printing durability, and tends to cause the printing unevenness. In the present invention, by smoothing the surface of the primer layer as mentioned below, the effects of the present invention are more pronounced when the Ra of the substrate surface is 0.04 µm or more. Ra of the substrate surface is more preferably 0.06 µm or more, and still more preferably 0.08 µm or more.

Ra of the substrate surface can be measured using a surface roughness tester "Surfcom" (registered trademark) 1400G (manufactured by Tokyo Seimitsu Co., Ltd.).

As another index of the smoothness of the substrate surface, in the present invention, a reference height of the substrate was set in the cross-section of the printing plate precursor, and attention was paid to protrusions and depressions of the substrate relative to the reference height. Within a 750 µm-wide region of the substrate in the cross-section, the sum of the total area of portions protruding from a reference height of the substrate (hereinafter sometimes abbreviated to "protrusion area") and the total area of portions recessing from a reference height of the substrate (hereinafter sometimes abbreviated to "depression area") is preferably 0 to 300 µm².

Here, the protrusion and depression areas within a 750 µm-wide region of the substrate in the cross-section of the printing plate precursor can be determined by observing the cross-section of the printing plate precursor using a SEM as mentioned below. In the present invention, in order to adequately suppress the measurement variation in the protrusion and depression areas of the substrate and to appropriately evaluate the smoothness of the substrate surface, the observation range was set within a 750 µm-wide region of the substrate.

By adjusting the sum of the protrusion and depression areas of the substrate to 300 µm² or less, the surface of the upper primer layer is also more easily smoothed, and therefore it becomes easier to design the maximum peak height and the sum of the protrusion and depression areas of the primer layer mentioned below within preferable ranges. As a result, the image reproducibility and printing durability can be further improved, and the printing unevenness can be further suppressed. The sum of the protrusion and depression areas of the substrate is more preferably 240 µm² or less, and still more preferably 180 µm² or less. Meanwhile, if the sum of the areas of the protrusion and depression areas of the substrate is 30 µm² or more, it is possible to produce the substrate by only rolling without performing a polishing treatment, so that the sum of the protrusion and depression areas of the substrate is 30 µm² or more, in view of improving the productivity of the substrate. As mentioned above, conventional printing plate precursors had a problem that roughening the substrate surface tends to cause deterioration of the image reproducibility and printing durability, and tends to cause the printing unevenness. However, in the present invention, by smoothing the surface of the primer layer as mentioned below, the effects of the present invention are more pronounced when the sum of the protrusion and depression areas of the substrate is 30 µm² or more. The sum of the protrusion and depression areas of the substrate is more preferably 45 µm² or more, and still more preferably 60 µm² or more.

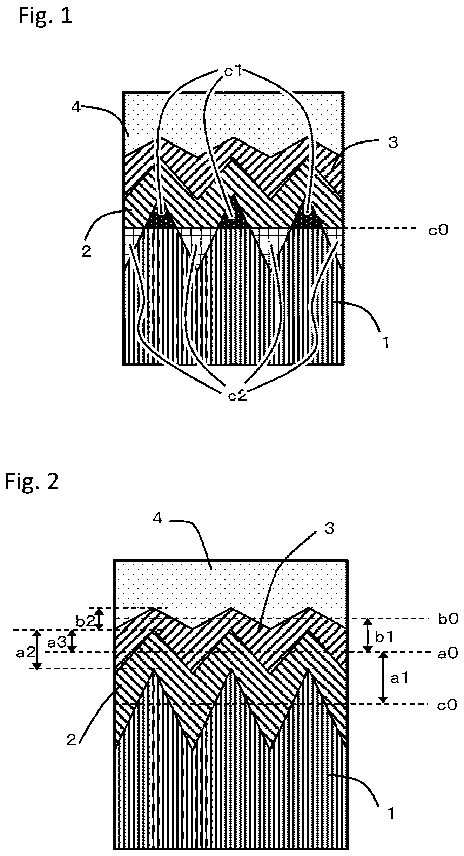

The relationship between a reference height of a substrate and the substrate in the present invention will be described with reference to FIG. 1. FIG. 1 is a cross-sectional schematic diagram showing an example of a conventionally known directly imageable waterless planographic printing plate precursor, which comprises, from the bottom, a substrate 1, a primer layer 2, a heat sensitive layer 3 and a silicone rubber layer 4. When the substrate 1 is an aluminum alloy plate, the surface generally has rolling marks formed during rolling, or protrusions and depressions formed by chemical, physical or electrochemical polishing treatment. In the present invention, the height of the surface position of the substrate when it is assumed that the substrate surface is smooth, determined as mentioned below, is defined as a reference height c0 of the substrate, and a portion that protrudes toward the primer layer 2 side from the reference height c0 of the substrate is represented as a portion c1 protruding from the reference height of the substrate, and a portion recessed toward the opposite side of the primer layer 2 from the reference height c0 of the substrate is represented as a portion c2 recessing from the reference height of the substrate, respectively. Here, in the cross-sectional SEM image of the printing plate precursor, the area of the substrate portion in the cross-sectional SEM image was divided by the observation width of the cross-sectional SEM image to calculate the average height of the substrate, and the reference height c0 of the substrate was determined by taking the obtained average height as the height from the base of the cross-sectional SEM image. Details will be mentioned below.

The sum of the protrusion and depression areas of the substrate can be determined by observing the cross-section of the printing plate precursor using a SEM. More specifically, the printing plate precursor is cut into 30 samples measuring 10 mm × 10 mm such that 30 different positions in the width direction are approximately at the center of each sample. Here, the 30 locations with different widthwise positions are selected as follows. The point 100 mm from one end of the width direction of the printing plate precursor is defined as the 1st location, and the point 100 mm from the other end is defined as the 30th location, and the points located on a length obtained by dividing the length between the 1st and 30th locations into 29 equal parts are defined as the 2nd to 29th locations, respectively. For example, in the case of a printing plate precursor having a width of 1,070 mm, the point 100 mm from one end in the width direction is the 1st location, the point 970 mm is the 30th location, and the points located at a length (30 mm) obtained by dividing the 870 mm in between into 29 equal parts are the 2nd to 29th locations. Specifically, the locations are 100, 130, 160, 190, 220, 250, 280, 310, 340, 370, 400, 430, 460, 490, 520, 550, 580, 610, 640, 670, 700, 730, 760, 790, 820, 850, 880, 910, 940 and 970 mm from one end of the width direction of the printing plate precursor, totaling 30 locations. After cutting, each of 30 samples was embedded in a resin, and then a cross-section perpendicular to the rolling marks of the aluminum substrate was prepared by the BIB method. The observation surface was subjected to a conductive treatment (Pt coating) to fabricate a sample for cross-sectional observation. The sample for cross-section observation thus obtained is observed using a scanning electron microscope (SEM) under the following observation conditions: backscattered electron image, acceleration voltage: 3.0 kV, and magnification: 5,000 times. In the thus obtained cross-sectional SEM images obtained at the 30 locations, a line representing the reference height of the substrate is drawn so as to be parallel to the line representing the interface between the silicone rubber layer and the embedding resin. The reference height of the substrate can be determined by calculating the average height of the substrate by dividing the area of the substrate portion in the cross-sectional SEM image by the observation width of each cross-sectional SEM image, and taking the thus obtained average height as the height from the base of the cross-sectional SEM image (the height from the base of the substrate if the base of the substrate is observed in the SEM image). In each cross-sectional SEM image, the sum of the protrusion and depression areas is calculated for a 25 µm width of the substrate located in the center of the width direction of the image, and the total values of the protrusion and depression areas for all 30 cross-sectional SEM images are added up, thereby making it possible to determine the sum of the protrusion and depression areas within a 750 µm width of the substrate in the cross-section.

Examples of means for adjusting the sum of the protrusion and depression areas of the substrate within the above-mentioned range include a method for forming roll marks during rolling, a method for chemically, physically or electrochemically polishing the substrate and the like.

The surface of the substrate may be subjected to a surface treatment such as a corona discharge treatment or a glow discharge treatment, thus enabling an increase in adhesive force between the substrate and the primer layer.

Next, the primer layer will be described.

In one embodiment of the present invention, the primer layer has a maximum peak height on its surface of 0.5 µm or less. By adjusting the maximum peak height on the surface of the primer layer to 0.5 µm or less, it is possible to improve the image reproducibility and printing durability and to suppress the printing unevenness. Although it is not clear why smoothing the surface of the primer layer improves the image reproducibility and printing durability and suppresses the printing unevenness, it is presumed that by providing a heat sensitive layer on a smooth primer layer with a maximum peak height of 0.5 µm or less on the surface of the primer layer, stress during printing is less likely to concentrate on protrusions of the surface of the heat sensitive layer, leading to an improvement in printing durability. By providing a heat sensitive layer on such a smooth primer layer, thin portions in the heat sensitive layer are less likely to occur, which is presumably why the image reproducibility is improved and the printing unevenness is suppressed. The maximum peak height on the surface of the primer layer is preferably 0.4 µm or less, and more preferably 0.3 µm or less.

The maximum peak height on the surface of the primer layer in the present invention will be described with reference to FIG. 2. FIG. 2 is a cross-sectional schematic diagram of an example of a conventionally known directly imageable waterless planographic printing plate precursor, which comprises, from the bottom, a substrate 1, a primer layer 2, a heat sensitive layer 3 and a silicone rubber layer 4. As mentioned above, when the substrate 1 is an aluminum alloy plate, there are protrusions and depressions on the surface. A method for applying a primer layer-forming composition is commonly used as a method for forming a primer layer 2 on a substrate 1. However, if a high-viscosity primer layer-forming composition is applied on the substrate 1 having protrusions and depressions on the surface, protrusions and depressions derived from protrusions and depressions of the substrate surface is also formed on the surface of the primer layer 2 due to drying and curing before leveling. In the present invention, the height from the reference height a0 of the primer layer 2 (height of the surface position of the primer layer when it is assumed that the primer layer is formed by completely leveling the primer layer-forming composition, determined as mentioned below) to the peak of the maximum protrusion is defined as the maximum peak height a3 on the surface of the primer layer. The average thickness of the primer layer mentioned below is a1, the thickness of the thinnest portion of the primer layer is a2, the average thickness of the heat sensitive layer is b1, and the thickness of the thinnest portion of the heat sensitive layer is b2. Here, in the cross-sectional SEM image of the printing plate precursor, the total area of the substrate portion and the primer layer portion of the cross-sectional SEM image was divided by the observation width of the cross-sectional SEM image to calculate the average height of the total of the substrate and the primer layer, and the reference height a0 of the primer layer was obtained by taking the thus obtained average height as the height from the bottom side of the cross-sectional SEM image. Details will be provided below.

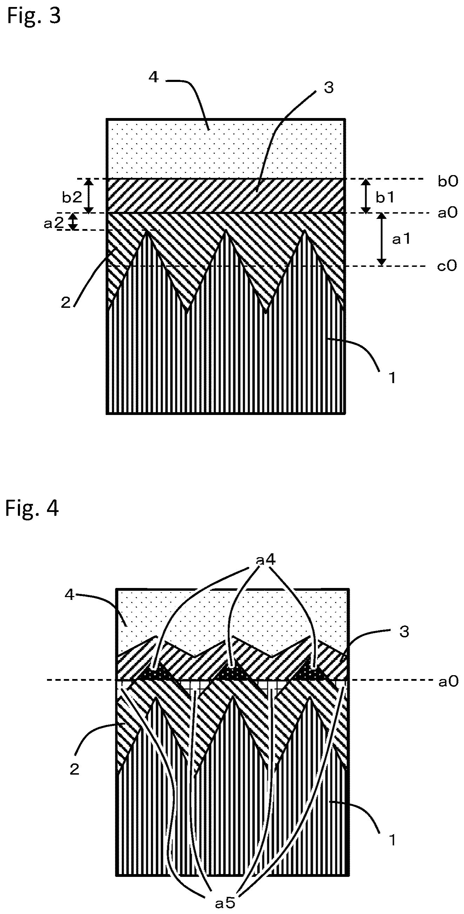

Meanwhile, FIG. 3 is a cross-sectional schematic diagram showing an example of a directly imageable waterless planographic printing plate precursor of the present invention, which comprises, from the bottom, a substrate 1, a primer layer 2, a heat sensitive layer 3 and a silicone rubber layer 4. For example, by applying a low-viscosity primer layer-forming composition with excellent leveling properties on a substrate 1 having protrusions and depressions on the surface, the primer layer-forming composition levels on the surface of the substrate 1 before drying or curing, resulting in a smooth surface of the primer layer 2. Here, it is preferable that the difference between the reference height a0 of the primer layer 2 and the surface of the primer layer 2 is small, and in FIG. 3, they coincide with each other. Furthermore, by providing the heat sensitive layer 3 on the primer layer 2 having a smooth surface, the surface of the heat sensitive layer 3 also becomes smooth.

The maximum peak height on the surface of the primer layer can be determined by observing the cross-section of the printing plate precursor using a SEM. More specifically, after the printing plate precursor is embedded in a resin, a cross-section is prepared by the BIB method. At this time, when the substrate has rolling marks, a cross-section perpendicular to the rolling marks is prepared. The observation surface is subjected to a conductive treatment (Pt coating) to fabricate a sample for cross-sectional observation. The sample for cross-section observation thus obtained is observed using a scanning electron microscope under the following observation conditions: backscattered electron image, acceleration voltage: 3.0 kV and magnification: 10 to 30,000 times (selected appropriately depending on the thickness of the primer layer). Cross-sectional SEM observation is performed on 30 locations randomly selected in the width direction, and the peak heights on the surface of the primer layer are determined in the cross-sectional SEM images of all 30 locations thus obtained. The portion with the highest peak height is defined as the maximum peak height on the surface of the primer layer. The reference height of the primer layer in each cross-sectional SEM image can be determined by dividing the total area of the substrate portion and the primer layer portion of the cross-sectional SEM image by the observation width of the cross-sectional SEM image to calculate the average height of the total of the substrate and the primer layer, and adjusting the obtained average height to the height from the base of the cross-sectional SEM image. The height of the peaks on the surface of the primer layer in each cross-sectional SEM image can be determined by measuring the height from the reference height of the primer layer determined by the above-mentioned method to the peak of the maximum protrusion of the primer layer in the cross-sectional SEM image.

Examples of means for adjusting the maximum peak height on the surface of the primer layer to 0.5 µm or less include a method for applying a primer layer-forming composition on a substrate having a smooth surface mentioned above, a method for lowering the viscosity of the primer layer-forming composition to enhance leveling properties, a method for ensuring a leveling time using a high-boiling point solvent in the primer layer-forming composition, a method for leaving a sufficient time between applying the primer layer-forming composition and heating to ensure leveling time, and a method for thickening the primer layer. These methods may also be combined.

As another index of the smoothness of the primer layer, in the present invention, the reference height of the primer layer was set on the cross-section of the printing plate precursor, and attention was paid to protrusions and depressions of the primer layer relative to the reference height. In one embodiment of the present invention, within a 750 µm-wide region of the primer layer in the cross-section, the sum of the total area of portions protruding from a reference height of the primer layer (hereinafter sometimes abbreviated to "protrusion area") and the total area of portions recessing from a reference height of the primer layer (hereinafter sometimes abbreviated to "depression area") is preferably 0 to 60 µm².

Here, the sum of the protrusion and depression areas of the primer layer can be determined by observing the cross-section of the printing plate precursor using an SEM as mentioned below. In the present invention, in order to adequately suppress the measurement variation in the protrusion and depression areas of the primer layer and to appropriately evaluate the smoothness of the primer layer surface, the observation range was set within a 750 µm-wide region of the primer layer.

By adjusting the sum of the protrusion and depression areas of the primer layer to 0 to 60 µm², it is possible to improve the image reproducibility and printing durability, and to suppress the printing unevenness. The reason why the image reproducibility is improved and the printing unevenness is suppressed by smoothing the primer layer surface is presumed to be the same as for the maximum peak height of the primer layer. The sum of the protrusion and depression areas of the primer layer is preferably 48 µm² or less, and more preferably 36 µm² or less.

The relationship between a reference height of a primer layer and the primer layer in the present invention will be described with reference to FIG. 4. FIG. 4 is a cross-sectional schematic diagram showing an example of a conventionally known directly imageable waterless planographic printing plate precursor, which comprises, from the bottom, a substrate 1, a primer layer 2, a heat sensitive layer 3 and a silicone rubber layer 4. As mentioned above, when the substrate 1 is an aluminum alloy plate, there are protrusions and depressions on the surface, and when a high-viscosity primer layer-forming composition is applied on such substrate 1, protrusions and depressions derived from protrusions and depressions of the substrate surface is also formed on the surface of the primer layer 2. In the present invention, with respect to the reference height a0 of the primer layer mentioned above, portions protruding toward the heat sensitive layer 3 side from the reference height a0 of the primer layer are represented as portions a4 protruding from the reference height of the primer layer, and protrusions recessed toward the substrate 1 side from the reference height a0 of the primer layer are represented as portions a5 recessing from the reference height of the primer layer, respectively.

Meanwhile, in the cross-sectional schematic diagram showing an example of a directly imageable waterless planographic printing plate precursor of the present invention shown in FIG. 3, the surface of the primer layer 2 is smooth, and the reference height a0 of the primer layer 2 coincides with the surface of the primer layer 2. That is, since there are neither portions protruding from the reference height of the primer layer nor portions recessed therefrom, the sum of the protrusion and depression areas is zero in FIG. 3.

Examples of means for adjusting the sum of the protrusion and depression areas of the primer layer to 0 to 60 µm² include a method for applying a primer layer-forming composition on a substrate having a smooth surface, a method for lowering the viscosity of the primer layer-forming composition to enhance leveling properties, a method for ensuring a leveling time using a high-boiling point solvent in the primer layer-forming composition, a method for leaving a sufficient time between applying the primer layer-forming composition and heating to ensure leveling time, and a method for thickening the primer layer. These methods may also be combined.

Within a 750 µm-wide region of the primer layer in the cross-section, the number of intersections between a reference height of the primer layer and a line representing an interface between the primer layer and the heat sensitive layer (hereinafter sometimes abbreviated to "number of intersections") is preferably 0 to 600. If the number of intersections is 600 or less, the number of protrusions of the primer layer, i.e., the number of thin film portions of the heat sensitive layer decreases, thus making it possible to improve the image reproducibility and to further suppress the printing unevenness. The number of intersections is more preferably 450 or less, and still more preferably 300 or less. In the present invention, in order to adequately suppress the measurement variation in number of intersections of the primer layer and to appropriately evaluate the smoothness of the primer layer surface, the observation range was set within a 750 µm-wide region of the primer layer.

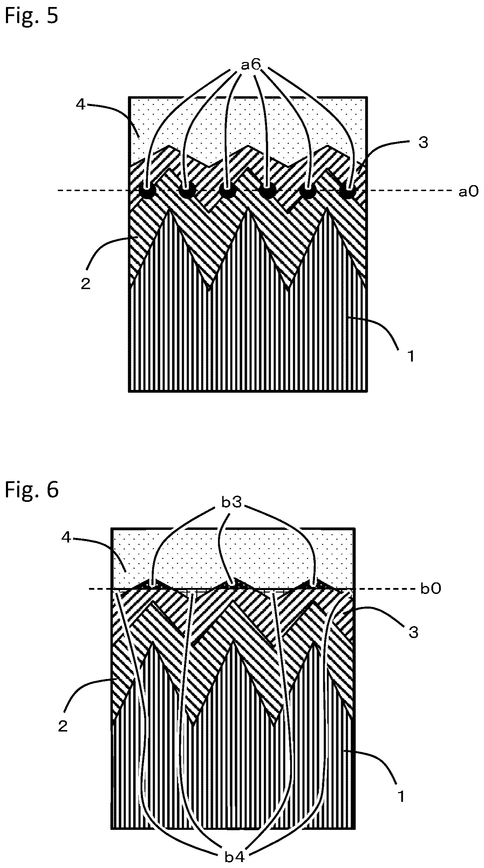

The intersections between a reference height of the primer layer and a line representing an interface between the primer layer and the heat sensitive layer in the present invention will be described with reference to FIG. 5. FIG. 5 is a cross-sectional schematic diagram showing an example of a directly imageable waterless planographic printing plate precursor, which comprises, from the bottom, a substrate 1, a primer layer 2, a heat sensitive layer 3 and a silicone rubber layer 4. The point where the reference height a0 of the primer layer mentioned above intersects with the line representing the interface between the primer layer 2 and the heat sensitive layer 3 is represented as the intersection a6 of the reference height of the primer layer with the line representing the interface between the primer layer and the heat sensitive layer.

Meanwhile, in the cross-sectional schematic diagram showing an example of a directly imageable waterless planographic printing plate precursor of the present invention shown in FIG. 3, the reference height a0 of the primer layer 2 coincides with the line representing the interface between the primer layer and the heat sensitive layer. In other words, the number of intersections between the reference height of the primer layer and the line representing the interface between the primer layer and the heat sensitive layer is zero.

The sum of the protrusion and depression areas of the primer layer and the number of intersections can be determined by observing the cross-section of the printing plate precursor using a SEM. More specifically, similarly to the case of determining the sum of the protrusion and depression areas of the substrate, 30 samples of the printing plate precursor measuring 10 mm × 10 mm at different positions in the width direction were cut and embedded in a resin, and then the cross-section perpendicular to the rolling marks of the aluminum substrate was prepared by the BIB method, and the observation surface was subjected to a conductive treatment (Pt coating) to fabricate samples for cross-sectional observation. The thus obtained sample for cross-section observation is observed using a scanning electron microscope under the following observation conditions: backscattered electron image, acceleration voltage: 3.0 kV and magnification: 5,000 times. In the cross-sectional SEM images thus obtained at the 30 locations, a line representing the reference height of the primer layer is drawn so as to be parallel to the line representing the interface between the silicone rubber layer and the embedding resin. In each cross-sectional SEM image, the sum of the protrusion and depression areas is calculated for a 25 µm wide portion of the primer layer located in the center of the width direction of the image, and the number of intersections between the reference height of the primer layer and the line representing the interface between the primer layer and the heat sensitive layer is counted. For each of them, the sum of the protrusion and depression areas and the number of intersections can be calculated by adding up all the values for the 30 cross-sectional SEM images.

Examples of means for adjusting the number of intersections to 0 to 600 include the means for adjusting the sum of the protrusion and depression areas of the substrate within the above-mentioned range, and the method mentioned as means for adjusting the maximum peak height and the sum of the protrusion and depression areas of the primer layer within the above-mentioned range.

The average thickness of the primer layer is preferably from 2 to 500 µm. When the average thickness is 2 µm or more, the influence of protrusions and depressions on the substrate surface can be suppressed, and the surface of the primer layer can be made smoother. Satisfactory hiding power and scratch resistance can also be obtained. The average thickness of the primer layer is more preferably 4 µm or more, and still more preferably 6 µm or more. Meanwhile, if the average thickness of the primer layer is 500 µm or less, dripping of the primer layer-forming composition during coating can be suppressed and the solvent can be efficiently volatilized from the primer layer-forming composition after coating, thus making it possible to make the surface smoother. The average thickness of the primer layer is preferably 400 µm or less, and more preferably 300 µm or less. The average thickness of the primer layer can be measured by cross-sectional SEM observation. More specifically, cross-sectional SEM observation is performed in the same manner as in the measurement of the maximum peak height on the surface of the primer layer, and the thickness can be determined by measuring the thickness at 20 randomly selected points from the thus obtained 30 cross-sectional SEM images, and calculating the arithmetic average value.

The thinnest portion of the primer layer preferably has a thickness of 1 µm or more. By adjusting the thickness of the thinnest portion of the primer layer to 1 µm or more, it is possible to prevent the heat generated by irradiation with laser light from being conducted to the substrate in the method for producing a planographic printing plate mentioned below, thus making it possible to further improve the image reproducibility and to further suppress the printing unevenness. The thickness of the thinnest portion of the primer layer is more preferably 2 µm or more, and still more preferably 3 µm or more. The thickness of the thinnest portion of the primer layer can be determined by cross-sectional SEM observation. More specifically, cross-sectional SEM observation is performed in the same manner as in measuring the maximum peak height on the surface of the primer layer, and the thickness of the thinnest portion of the primer layer is measured in all 30 cross-sectional SEM images thus obtained.

Examples of the means for adjusting the thinnest portion of the primer layer to 1 µm or more include a method for making the primer layer thicker.

In the present invention, the light transmittance of the primer layer is preferably 15% or less for all wavelengths from 400 to 650 nm. If the light transmittance of the primer layer is 15% or less, mechanical plate inspection becomes possible. The light transmittance of the primer layer is more preferably 10% or less, and still more preferably 5% or less.

The light transmittance of the primer layer can be measured, for example, by using a visible spectrophotometer. If the substrate is transparent, the measurement can be made by the transmission method, and if the substrate is opaque, the measurement can be made by the reflection method. Examples of such visible spectrophotometer include a self-recording spectrophotometer U-3210 manufactured by Hitachi, Ltd.

Next, the heat sensitive layer in the printing plate precursor of the present invention will be described.

Examples of the heat sensitive layer for a directly imageable waterless planographic printing plate precursor include thermally-soluble, thermally-expandable, thermally-ablatable, thermally-separable and thermally-curable heat sensitive layers that have been disclosed so far as heat sensitive layer for directly imageable waterless planographic printing plate.

### [Thermally-soluble Heat Sensitive Layer]

A thermally-soluble heat sensitive layer is a type of a heat sensitive layer having a crosslinked structure formed by a crosslinking agent, when it is included in a printing plate precursor, and whose adhesive force to the silicone rubber layer is reduced due to heat generated by the irradiation with laser light. A subsequent developing treatment removes the portions of the silicone rubber layer irradiated with the laser light. Most of the portions of the heat sensitive layer irradiated with the laser light remain after the development. The thermally-soluble heat sensitive layer may be, for example, a layer obtained by coating and (heat) drying a composition including a polymer containing active hydrogen, a crosslinking agent, and a photothermal conversion material, or a diluted solution thereof; or alternatively, a composition including a polymer containing active hydrogen, an organic complex compound, and a photothermal conversion material, or a diluted solution thereof. The polymer containing active hydrogen is preferably a homopolymer or a copolymer of p-hydroxystyrene, or a polymer having a phenolic hydroxyl group, such as a novolac resin or a resole resin. Examples of the crosslinking agent include organic complex compounds, polyfunctional isocyanates, polyfunctional blocked isocyanates, polyfunctional epoxy compounds, polyfunctional (meth)acrylate compounds, polyfunctional aldehydes, polyfunctional mercapto compounds, polyfunctional alkoxysilyl compounds, polyfunctional amine compounds, polyfunctional carboxylic acids, polyfunctional vinyl compounds, polyfunctional diazonium salts, polyfunctional azide compounds, hydrazine and the like. The organic complex compound may be, for example, an acetylacetone complex or an acetoacetic acid ester complex of Al(III), Fe(II), Fe(III), Ti (IV) or Zr(IV). The photothermal conversion material may be, for example, a dye or a pigment capable of absorbing infrared radiation or near-infrared radiation. Specific examples of the thermally-soluble heat sensitive layer include the heat sensitive layers disclosed in JP 11-221977 A, JP 2004-334025 A, JP 2005-309126 A, and JP 2009-014946 A.

### [Thermally-Expandable Heat Sensitive Layer]

Specific examples of the thermally-expandable heat sensitive layer include the heat sensitive layers containing gas bubbles, which are disclosed in JP 2005-300586 A and JP 2005-331924 A; and the heat sensitive layers containing liquid bubbles, which are disclosed in WO 2010/113989 A1.

A printing plate precursor containing gas bubbles or liquid bubbles and having a high sensitivity can be developed simply by applying physical forth thereto, after the exposure. Therefore, in a step of producing a printing plate, there are cases where a phenomenon referred to as "blistering" may occur, in which the exposed portions of the silicone rubber layer float or swell to form blistering. "Blistering" may cause exposure defects, development defects and the like, and blistering are more likely to occur when the printing plate precursor has a higher sensitivity, and as the light exposure is increased.

Specific examples of the thermally-expandable heat sensitive layer for preventing such blister phenomenon include: the heat sensitive layers containing nonphotosensitive particles, which are disclosed in JP 2012-93728 A, JP 2012-133321 A, JP 2012-133322 A, WO 2012/043282 A1 and the like; and the heat sensitive layer containing at least a novolac resin disclosed in WO 2012/099003 A1, a polyurethane, and a photothermal conversion material, and having a phase-separated structure which includes at least a phase containing the novolac resin and a phase containing the polyurethane.

### [Thermally-Ablatable Heat Sensitive Layer]

A thermally-ablatable heat sensitive layer is a type of a heat sensitive layer which is thermally ablated by the irradiation with laser light. A subsequent developing treatment removes, along with the ablated portions of the heat sensitive layer, the portions of silicone rubber layer present at the surface thereon, thereby forming the image area. Specific examples of the thermally-ablatable heat sensitive layer include the heat sensitive layers disclosed in JP 7-314934, JP 9-086065 A, JP 9-131981 A, US 5,353,705 and US 10,011,137.

### [Thermally-separable Heat Sensitive Layer]

A thermally-separable heat sensitive layer is a second layer on which a printing pattern is formed in the following image formation system: an image formation system which uses a printing member including a first layer and a second layer adhered to the first layer, wherein the first layer and the second layer have different affinities for at least one printing liquid selected from the group consisting of inks and ink repellent liquids; and in which system the printing member is heated to allow the first layer to be irreversibly detached from the second layer in an imagewise pattern, without substantially ablating the second layer; or an image formation system which uses a printing member including a first layer, a second layer adhered to the lower side of the first layer and a third layer disposed to the lower side of the second layer, wherein the first layer and at least one of the other layers have different affinities for at least one printing liquid selected from the group consisting of inks and ink repellent liquids, and in which system, the printing member is heated to allow the first layer to be irreversibly detached from the second layer in an imagewise pattern without ablating the second layer. Specific examples of the thermally-separable heat sensitive layer include the heat sensitive layer disclosed in US 6,107,001.

### [Thermally-curable Heat Sensitive Layer]

A thermally-curable heat sensitive layer is a type of heat sensitive layer in which a crosslinked structure is formed by a thermally activated crosslinking agent due to heat generated by the irradiation with laser light. After a developing treatment carried out subsequently, the portions of the silicone rubber layer irradiated with the laser light remain, and the unirradiated portions of the silicone rubber layer are removed. The portions of the heat sensitive layer not irradiated with the laser light remain after the development. Specific examples of the thermally-curable heat sensitive layer include the thermally-curable heat sensitive layers disclosed in JP 11-157236 A and JP 11-240271 A.

Of these heat sensitive layers, thermally-soluble, thermally-expandable and thermally-ablatable heat sensitive layers are preferable since they have high sensitivity and are more excellent in image reproducibility, and can further suppress the printing unevenness. Among them, using a thermally-ablatable heat sensitive layer in which the heat sensitive layer of the exposed area is removed during the plate-making process is more preferable since it allows plate inspection without the need for dyeing the image area after development.

The average thickness of the heat sensitive layer is preferably 0.5 to 2.0 µm. By adjusting the average thickness of the heat sensitive layer to 0.5 µm or more, it is possible to enhance the heat generation efficiency and to further improve the image reproducibility and sensitivity, and to further suppress the printing unevenness. Meanwhile, by adjusting the average thickness of the heat sensitive layer to 2.0 µm or less, the solvent can be easily evaporated from the coating film, and in the case of the thermally-ablatable heat sensitive layer, thermal ablation can be easily achieved to the lower portion of the heat sensitive layer, thus making it possible to further improve the image reproducibility and plate inspection properties.

The thickness of the thinnest portion of the heat sensitive layer is preferably 0.2 µm or more. By adjusting the thickness of the thinnest portion of the heat sensitive layer to 0.2 µm or more, it is possible to enhance the heat generation efficiency and to further improve the image reproducibility and sensitivity, and to further suppress the printing unevenness. The thickness of the thinnest portion of the heat sensitive layer is preferably 0.3 µm or more, and more preferably 0.4 µm or more.

As an index of the smoothness of the heat sensitive layer, in the present invention, a reference height of the heat sensitive layer was set in the cross-section of the printing plate precursor, and attention was paid to protrusions and depressions of the heat sensitive layer relative to the reference height. Within a 750 µm-wide region of the heat sensitive layer in the cross-section of the printing plate precursor, the sum of the total area of portions protruding from a reference height of the heat sensitive layer (hereinafter sometimes abbreviated to "protrusion area") and the total area of portions recessing from a reference height of the heat sensitive layer (hereinafter sometimes abbreviated to "depression area") is preferably 0 to 30 µm². By adjusting the sum of the protrusion and depression areas of the heat sensitive layer to 30 µm² or less, it is possible to further improve the printing durability. The sum of the protrusion and depression areas of the heat sensitive layer is more preferably 24 µm² or less, and still more preferably 18 µm² or less. Here, the sum of the protrusion and depression areas of the heat sensitive layer can be determined by observing the cross-section of the printing plate precursor using a SEM as mentioned below. In the present invention, in order to adequately suppress the measurement variation in the protrusion and depression areas of the heat sensitive layer and to appropriately evaluate the smoothness of the heat sensitive layer surface, the observation range was set within a 750 µm-wide region of the heat sensitive layer.

The relationship between a reference height of a heat sensitive layer and the heat sensitive layer in the present invention will be described with reference to FIG. 6. FIG. 6 is a cross-sectional schematic diagram showing an example of a conventionally known directly imageable waterless planographic printing plate precursor, which comprises, from the bottom, a substrate 1, a primer layer 2, a heat sensitive layer 3 and a silicone rubber layer 4. A method for applying a heat sensitive layer-forming composition is generally used as the method for forming a heat sensitive layer 3 on a primer layer 2. However, when a heat sensitive layer-forming composition, particularly a high-viscosity heat sensitive layer-forming composition, is applied on a primer layer 2 having protrusions and depressions on the surface, protrusions and depressions derived from protrusions and depressions of the primer layer surface are likely to be formed on the surface of the heat sensitive layer 3 due to drying and curing before leveling. In the present invention, the height of the surface position of the heat sensitive layer when it is assumed that the heat sensitive layer-forming composition has completely leveled to form a heat sensitive layer, determined as mentioned below, is defined as the reference height b0 of the heat sensitive layer 3, and a portion that protrudes toward the silicone rubber layer 4 side from the reference height b0 of the heat sensitive layer is represented as a portion b3 protruding from the reference height of the heat sensitive layer, and a portion recessed toward the primer layer 2 side from the reference height b0 of the heat sensitive layer is represented as a portion b4 recessing from the reference height of the heat sensitive layer, respectively. Here, in the cross-sectional SEM image of the printing plate precursor, the total area of the substrate portion, the primer layer portion and the heat sensitive layer portion in the cross-sectional SEM image was divided by the observation width of the cross-sectional SEM image to calculate the total average height of the substrate, the primer layer and the heat sensitive layer, and the reference height b0 of the heat sensitive layer 3 was determined by taking the obtained total average height as the height from the base of the cross-sectional SEM image. Details will be mentioned below.

Meanwhile, in the cross-sectional schematic diagram showing an example of a directly imageable waterless planographic printing plate precursor of the present invention shown in FIG. 3, the surface of the primer layer 2 is smooth. For example, by applying a low-viscosity heat sensitive layer-forming composition with excellent leveling properties on the primer layer 2 having a smooth surface, the heat sensitive layer-forming composition levels on the surface of the primer layer 2 before drying or curing, so that the surface of the heat sensitive layer 3 also becomes smooth and the reference height b0 of the heat sensitive layer 3 coincides with the surface of the heat sensitive layer 3. That is, since there are neither portions protruding from the reference height of the heat sensitive layer nor portions recessing from the heat sensitive layer, the sum of the protrusion and depression areas is zero in FIG. 3.

The sum of the protrusion and depression areas of the heat sensitive layer can be determined by observing the cross-section of the printing plate precursor using a SEM. More specifically, similarly to the case of determining the sum of the protrusion and depression areas of the substrate, 30 samples of the printing plate precursor measuring 10 mm × 10 mm at different positions in the width direction were cut and embedded in a resin, and then the cross-section perpendicular to the rolling marks of the aluminum substrate was prepared by the BIB method, and the observation surface was subjected to a conductive treatment (Pt coating) to fabricate samples for cross-sectional observation. The thus obtained sample for cross-section observation is observed using a scanning electron microscope under the following observation conditions: backscattered electron image, acceleration voltage: 3.0 kV and magnification: 5,000 times. In the cross-sectional SEM images thus obtained at 30 locations, a line representing the reference height of the heat sensitive layer is drawn so as to be parallel to the line representing the interface between the silicone rubber layer and the embedding resin. In each cross-sectional SEM image, the sum of the protrusion and depression areas is calculated for a 25 µm width of the heat sensitive layer located in the center of the width direction of the image, and the sum of the protrusion and depression areas is obtained by adding up all the values for the 30 cross-sectional SEM images.

Examples of means for adjusting the sum of the protrusion and depression areas of the heat sensitive layer to 0 to 30 µm² include a method for applying a heat sensitive layer-forming composition on a primer layer having a smooth surface, a method for lowering the viscosity of the heat sensitive layer-forming composition to enhance leveling properties, a method for ensuring a leveling time using a high-boiling point solvent in the heat sensitive layer-forming composition, a method for leaving a sufficient time between applying the heat sensitive layer-forming composition and heating to ensure leveling time, and a method for thickening the heat sensitive layer. These methods may also be combined.

Examples of the silicone rubber layer include addition reaction type, condensation reaction type, and addition reaction-condensation reaction combined type silicone rubber layers that have been disclosed so far as ink-repellent layers for waterless planographic printing plates.

Examples of the addition reaction type, condensation reaction type, or addition reaction-condensation reaction combined type silicone rubber layer include a layer exemplified as a diorganosiloxane unit-including layer in JP 2021-66175 A, a layer exemplified as a silicone rubber layer in WO 2019/203261 A1, a layer exemplified as a first silicone layer in WO 2019/203263 A1 and the like.

The silicone rubber layer preferably contains hard domains, which can further improve the printing durability and scratch resistance. The presence or absence of hard domains in the silicone rubber layer can be analyzed by a force volume method using an atomic force microscope with a sharp-tip probe and a minimal load. The elastic modulus only of the silicone layer excluding the effect of the lower layers and the substrate can be accurately measured using a silicon or silicon nitride probe having a tip radius of curvature of 5 to 20 nm under a load of 1 to 20 nN. The force volume method is a method in which a probe (cantilever) is moved vertically, pressed against the layer surface, and then released, and the series of operation is repeated to perform two-dimensional scanning with the probe. In this process, a force curve is acquired for each cycle, and analysis of this curve makes it possible to map mechanical properties such as elastic modulus. In the present invention, when the elastic modulus at all measurement points within the obtained scanning range is mapped and the whole is taken as 100 area%, if the proportion of island parts having a high elastic modulus of 100 MPa or more in sea parts having a low elastic modulus of 10 MPa or less is less than 0.5 area%, it is determined that no hard domain is contained, and if the proportion of island parts having a high elastic modulus of 100 MPa or more is 0.5 area% or more, it is determined that hard domains are contained.

The hard domains are mainly composed of reaction aggregates of the crosslinking agent. Examples of the crosslinking agent for the addition reaction type silicone rubber layer include a siloxane compound having three or more SiH groups in the molecule. Examples of the crosslinking agent for the condensation reaction type silicone rubber layer include a silane coupling agent. Examples of the crosslinking agent for the addition reaction-condensation reaction combined type silicone rubber layer include a siloxane compound having three or more SiH groups in the molecule, a silane coupling agent and the like.

The average thickness of the silicone rubber layer is preferably 2 to 20 µm. By adjusting the average thickness of the silicone rubber layer to 2 µm or more, it is possible to further improve the ink repellency, scratch resistance and printing durability. The average thickness of the silicone rubber layer is more preferably 2.5 µm or more, still more preferably 3.0 µm or more, and yet more preferably 3.2 µm or more. Meanwhile, by adjusting the average thickness of the silicone rubber layer to 20 µm or less, it is possible to further improve the image reproducibility and to further suppress the printing unevenness. The average thickness of the silicone rubber layer is more preferably 15 µm or less, still more preferably 10 µm or less, and yet more preferably 4.8 µm or less. The average thickness of the silicone rubber layer can be measured by cross-sectional SEM observation, and can be determined in the same manner as the above-mentioned method for measuring the average thickness of the primer layer.

The silicone rubber layer may also contain a liquid having a surface tension of 30 mN/m or less at 25°C, which can improve the ink repellency. Examples of the liquid having a surface tension of 30 mN/m or less at 25°C include liquids disclosed in WO 2016/076286 A1 and the like.

The printing plate precursor according to the present invention may further include a cover film and/or an interleaving paper on the silicone rubber layer, thus making it possible to protect the surface of the silicone rubber layer.

The cover film is preferably a film having a thickness of 100 µm or less. Specific examples thereof include films of polyethylene, polypropylene, polyvinyl chloride, polyethylene terephthalate, cellophane and the like.

The interleaving paper preferably has a basis weight of 30 to 90 g/m². Examples of preferably used interleaving papers include information recording paper 40 g/m² (manufactured by Nagoya Pulp K.K.), metal-containing interleaving paper 30 g/m² (manufactured by Nagoya Pulp K.K.), unbleached kraft paper 50 g/m² (manufactured by Chuetsu Pulp & Paper Co., Ltd.), NIP paper 52 g/m² (manufactured by Chuetsu Pulp & Paper Co., Ltd.), pure white roll paper 45 g/m² (manufactured by Oji Paper Co., Ltd.), Clupak 73 g/m² (manufactured by Oji Paper Co., Ltd.) and the like.

Next, a method for producing a printing plate precursor according to the present invention will be described.

The method for producing a printing plate precursor according to the present invention preferably comprises at least the steps of:
(1) applying a primer layer-forming composition on a substrate, and drying/curing the composition with or without heating to obtain a primer layer;
(2) applying a heat sensitive layer-forming composition on the primer layer obtained in the step (1), and drying/curing the composition with or without heating to obtain a heat sensitive layer; and
(3) applying a silicone rubber layer-forming composition on the heat sensitive layer obtained in the step (2), and drying/curing the composition with or without heating to obtain a silicone rubber layer.

Examples of a method for coating the primer layer-forming composition include methods using a slit die coater, a lip coater, a gravure coater, a direct roll coater, a reverse roll coater, a wire bar coater and the like. Of these, coating using a slit die coater or lip coater, which are closed system coating methods, is preferred.

In the case of heating, examples of the heating device include a hot air dryer, an infrared dryer and the like. The heating temperature is preferably 50 to 200°C, and the heating time is preferably 30 seconds to 10 minutes.

Examples of the method for coating a heat sensitive layer-forming composition include the methods exemplified as the method for coating a primer layer-forming composition, and coating using a slit die coater or lip coater, which is a closed system coating method, is preferable.

When heating is performed, preferred heating conditions are the same as those for the primer layer.

Examples of the method for coating a silicone rubber layer-forming composition include the methods exemplified as the methods for coating a primer layer-forming composition, and coating using a closed system coating method such as a slit die coater or lip coater is preferred. Upon coating, it is preferable to remove as much moisture as possible from the surface of the heat sensitive layer in order to improve the adhesion.

When heating, the preferred heating conditions are the same as those for the primer layer.

Next, a primer layer-forming composition that is suitably used in the method for producing a printing plate precursor according to the present invention will be described.

The primer layer-forming composition in the present invention preferably contains a polyurethane, an active hydrogen group-containing aromatic compound and a metal chelate compound.

Polyurethane is generally obtained by reacting a polyisocyanate with a polyhydric alcohol. Examples of polyisocyanate include paraphenylene diisocyanate, toluylene diisocyanate, diphenylmethane diisocyanate, tolidine diisocyanate, xylylene diisocyanate, hexamethylene diisocyanate, isophorone diisocyanate and the like. Examples of polyhydric alcohol include ethylene glycol, propylene glycol, 1,4-butanediol, 1,6-hexanediol, diethylene glycol, dipropylene glycol, polyethylene glycol, polypropylene glycol, glycerin, trimethylolpropane and the like.

The content of polyurethane is preferably 10 to 75% by mass in the total solid content of the primer layer-forming composition. Here, the total solid content of the primer layer-forming composition refers to the components remaining after the primer layer-forming composition is applied, dried and the volatile components are removed. The same applies to the definition of the total solid content in other layers-forming compositions. By adjusting the content of polyurethane to 10% by mass or more, the scratch resistance can be improved. Meanwhile, by adjusting the content of polyurethane to 75% by mass or less, the development latitude can be widened.

Examples of the active hydrogen group-containing aromatic compound include hydroxyl group-containing aromatic compounds, amino group-containing aromatic compounds, carboxyl group-containing aromatic compounds, thiol group-containing aromatic compounds and the like. Of these, hydroxyl group-containing aromatic compounds are preferable.

Examples of the hydroxyl group-containing aromatic compound include phenolic hydroxyl group-containing compounds, aromatic epoxy resins and the like.

Examples of the phenolic hydroxyl group-containing compound include hydroquinone, catechol, guaiacol, cresol, xylenol, naphthol, dihydroxyanthraquinone, dihydroxybenzophenone, trihydroxybenzophenone, tetrahydroxybenzophenone, bisphenol A, bisphenol S, novolak resin, resol resin, resorcin-benzaldehyde resins, pyrogallol acetone resins, hydroxystyrene polymers and copolymers, rosin-modified phenolic resins, epoxy-modified phenolic resins, lignin-modified phenolic resins, aniline-modified phenolic resins, melamine-modified phenolic resins, bisphenols and the like.

Examples of the aromatic epoxy resin include bisphenol A glycidyl esters, other bisphenol A type epoxy resins, bisphenol F diglycidyl esters, other bisphenol F type epoxy resins, bisphenol AD diglycidyl esters, other bisphenol AD type epoxy resins, terephthalic acid diglycidyl esters, glycidyl phthalimide, dibromophenyl glycidyl esters, phenol novolac type epoxy resins, cresol novolac type epoxy resins, reaction products of aniline and epichlorohydrin, reaction products obtained by co-condensing phenol and aniline with formaldehyde and epoxidizing with novolac type resins, reaction products of tolylene diisocyanate and glycidol and the like.

The content of the active hydrogen group-containing aromatic compound is preferably 15 to 50% by mass in the total solid content of the primer layer-forming composition. By adjusting the content of the active hydrogen group-containing aromatic compound to 15% by mass or more, satisfactory adhesion to the substrate and the heat sensitive layer is achieved, and the resistance to solvents is also enhanced. The crosslinking reaction with the metal chelate compound mentioned below proceeds sufficiently, thus making it possible to further improve image reproducibility and to further suppress the printing unevenness. Meanwhile, by adjusting the content of the active hydrogen group-containing aromatic compound to 50 mass% or less, it is possible to suppress extraction of the unreacted active hydrogen group-containing aromatic compound into the heat sensitive layer-forming composition and to further improve the image reproducibility, and to further suppress the printing unevenness.

Examples of the metal chelate compound include organic complex salts in which an organic ligand that contains two or more coordinating groups in the molecule and can form one or more cyclic structures with metal is coordinated to the metal.

Examples of the metal include Al, Ti, Mn, Fe, Co, Ni, Cu, Zn, Ge, In, Sn, Zr, Hf and the like. Al or Zr is preferable in view of the resistance to coloration, and Al is more preferable in view of the reactivity.

Examples of the organic ligand that contains two or more coordinating groups in the molecule and can form one or more cyclic structures with metal include β-diketones, ketoesters, diesters, hydroxycarboxylic acids or esters or salts thereof, ketoalcohols, aminoalcohols, enolic active hydrogen compounds and the like. In view of pot life, β-diketones and ketoesters are preferable, and in view of the reactivity, ketoesters are more preferable.

Specific examples of β-diketones and ketoesters include the following:
(1) β-diketones: 2,4-pentanedione, 2,4-heptanedione, trifluoroacetylacetone, hexafluoroacetylacetone, dibenzoylmethane, benzoylacetone, benzoyltrifluoroacetone, and the like.
(2) ketoesters: methyl acetoacetate, ethyl acetoacetate, butyl acetoacetate, octyl acetoacetate and the like.

The metal chelate compound used in the present invention is preferably an alumichelate compound in which two or more ketoesters are coordinated to aluminum. By coordinating two or more ketoesters, it is possible to suppress the crosslinking reaction in the primer layer-forming composition and to adjust the viscosity of the primer layer-forming composition within the preferred range mentioned below, and to make the surface of the primer layer smoother. The pot life of the primer layer-forming composition is improved dramatically. Meanwhile, when heated, the alumichelate compound easily exchanges ligands with the active hydrogen-containing compound to cause a crosslinking reaction, resulting in excellent curability and suppression of sublimation or evaporation of the alumichelate compound itself.

The content of the metal chelate compound is preferably 1 to 30% by mass in the total solid content of the primer layer-forming composition. By adjusting the content of the metal chelate compound to 1% by mass or more, satisfactory adhesion to the substrate and the heat sensitive layer is achieved, and the resistance to solvents is also increased. Furthermore, the crosslinking reaction with the aromatic compound containing an active hydrogen group proceeds sufficiently, thus making it possible to further improve the image reproducibility and to further suppress the printing unevenness. The content of the metal chelate compound is more preferably 2% by mass or more. Meanwhile, by adjusting the metal chelate compound to 30% by mass or less, it is possible to suppress extraction of the unreacted metal chelate compound into the heat sensitive layer-forming composition. The content of the metal chelate compound is more preferably 20% by mass or less.

The primer layer-forming composition in the present invention preferably contains a pigment. By including the pigment, it is possible to adjust the light transmittance of the primer layer to 15% or less for all wavelengths from 400 to 650 nm. This improves plate inspection properties by machine reading. As the pigment, preferred are inorganic white pigments such as titanium oxide, zinc oxide and lithopone; inorganic yellow pigments such as yellow lead, cadmium yellow, yellow iron oxide, ochre and titanium yellow; and organic yellow pigments. It is preferable to use, as the organic yellow pigment, azo pigments such as acetoacetate arylide-based monoazo pigments, acetoacetate arylide-based disazo pigments, fused azo pigments and benzimidazolone-based monoazo pigments; and polycyclic pigments such as isoindolinone-based pigments, isoindoline-based pigments, threne-based pigments, perinone-based pigments, metal complex pigments, anthrapyrimidine-based pigments, acylamino yellow-based pigments, quinophthalone-based pigments and flavanthrone-based pigments. Of these pigments, titanium oxide is particularly preferable in view of the hiding power and tinting power. Titanium oxide may be surface-treated with hydrous alumina, silica, hydrous titania, hydrous zirconia or the like for the purpose of improving the dispersibility and weatherability. The surface of the titanium oxide subjected to such surface treatment may be further treated with a pigment dispersant such as a titanate-based coupling agent. Such treatment further suppresses the filler effect, and the thickening of the primer layer-forming composition can be further suppressed to maintain the viscosity low, thus making it possible to make the surface of the primer layer smoother. Since the dispersibility of titanium oxide is improved, it becomes possible to increase the content of titanium oxide particles. Furthermore, the dispersion stability of the titanium oxide particles in the primer layer-forming composition is improved.

The particle size of titanium oxide is preferably 0.2 to 0.4 µm in terms of primary particle size. If the primary particle size is 0.2 µm or more, the hiding power can be improved. Meanwhile, if the primary particle size is 0.4 µm or less, spontaneous sedimentation is unlikely to occur, and a primer layer-forming composition solution with stable dispersion can be obtained, thus making it possible to obtain a satisfactory coating film with gloss.

The content of the pigment is preferably 2 to 30% by volume in the total solid content of the primer layer-forming composition. By adjusting the pigment content to 2% by volume or more, satisfactory hiding performance can be obtained. Meanwhile, by adjusting the pigment content to 30% by volume or less, satisfactory coating performance is exhibited, thus making it possible to further improve the scratch resistance, printing durability and image reproducibility.

The primer layer-forming composition in the present invention preferably contains alkyl ethers (e.g., ethyl cellulose, methyl cellulose, etc.), fluorine-based surfactants, silicone-based surfactants, nonionic surfactants and the like for the purpose of further improving the leveling properties to make the surface of the primer layer smoother.

The primer layer-forming composition preferably contains a solvent. By including a solvent, since the viscosity of the primer layer-forming composition can be significantly reduced, leveling properties are improved and the surface of the primer layer becomes smoother.

The solvent used in the primer layer-forming composition preferably has the property of dissolving polyurethane, an active hydrogen group-containing aromatic compound, a metal chelate compound and other additives well. When the pigment is added, it is preferable to select a solvent that can thoroughly wet the pigment surface and provide satisfactory pigment dispersibility. Two or more solvents may be included.

The viscosity of the primer layer-forming composition is preferably 3 to 100 mPa·s at a liquid temperature of 25°C. The viscosity at a liquid temperature of 25°C is an index that represents the state of the primer layer-forming composition when the primer layer is formed. By adjusting the viscosity of the primer layer-forming composition to 3 mPa·s or more, dripping of the primer layer-forming composition and bead break during coating are suppressed and the surface of the primer layer is made smoother, thus making it possible to further reduce the maximum peak height and the sum of the protrusion and depression areas on the surface of the primer layer. The viscosity of the primer layer-forming composition is more preferably 5 mPa·s or more. Meanwhile, by adjusting the viscosity of the primer layer-forming composition to 100 mPa·s or less, leveling on the substrate surface becomes easier and the surface of the primer layer can be made smoother, thus making it possible to reduce the maximum peak height and the sum of the protrusion and depression areas on the surface of the primer layer. The viscosity of the primer layer-forming composition is more preferably 50 mPa·s or less.

The viscosity of the primer layer-forming composition at a liquid temperature of 25°C can be measured by a rotational viscometer.

The viscosity of the primer layer-forming composition at a liquid temperature of 25°C can be adjusted within the above-mentioned range, for example, by adjusting the solids concentration of the primer layer-forming composition.

The solids concentration of the primer layer-forming composition is preferably 1 to 5% by mass from the viewpoint of adjusting the viscosity of the primer layer-forming composition at a liquid temperature of 25°C within the above-mentioned range. By adjusting the solids concentration to 1% by mass or more, the surface can be made smoother, thus making it possible to further reduce the maximum peak height and the sum of the protrusion and depression areas on the surface of the primer layer. The solids concentration of the primer layer-forming composition is more preferably 2% by mass or more. Meanwhile, by adjusting the solids concentration to 5% by mass or less, the surface of the primer layer can be made smoother, thus making it possible to further reduce the maximum peak height and the sum of the protrusion and depression areas on the surface of the primer layer. The solids concentration of the primer layer-forming composition is more preferably 4% by mass or less.

The primer layer-forming composition can be obtained, for example, by a method in which a titanium oxide dispersion is charged in a container and, after starting stirring, an epoxy resin and a polyurethane solution are added in small portions to prepare a high-concentration dispersion, and then a solvent, a crosslinking agent and a leveling agent are added in this order, followed by stirring until the components are uniform.

The titanium oxide dispersion can be obtained, for example, by adding titanium oxide and, if necessary, a titanate-based coupling agent to a solvent, and dispersing the mixture with a dispersing machine such as a paint shaker, a ball mill or a bead mill.

Examples of the heat sensitive layer-forming composition include compositions disclosed in JP 2004-334025 A and US 10,011,137.

Examples of the silicone rubber layer-forming composition include composition exemplified in JP 2021-66175 A as a diorganosiloxane unit-including layer-forming composition, a composition exemplified in WO 2019/203261 A1 as a silicone rubber layer-forming composition, and a composition exemplified in WO 2019/203263 A1 as a first silicone layer-forming composition.

When forming a silicone rubber layer containing hard domains, the silicone rubber layer-forming composition preferably contains the above-mentioned crosslinking agent, and hard domains mainly composed of reaction aggregates of the crosslinking agent can be easily formed when the silicone rubber layer-forming composition is dried or cured.

Examples of the siloxane compound having three or more SiH groups in the molecule include organohydropolysiloxanes, organohydrosiloxane-diorganosiloxane copolymers, and compounds having three or more diorganohydrosiloxy groups in the molecule. Two or more of these may be contained. Of these, organohydropolysiloxanes and organohydrosiloxane-diorganosiloxane copolymers are preferable.

The molecular structure of the organohydropolysiloxanes or organohydrosiloxane-diorganosiloxane copolymers may be a linear, cyclic, branched or network structure. The organic groups bonded to the silicon atom may be the same or different, and each is preferably a monovalent organic group that does not contain an aliphatic unsaturated bond. Examples of the monovalent organic group containing no aliphatic unsaturated bond include alkyl groups such as a methyl group, an ethyl group, a propyl group, a butyl group, a pentyl group, a hexyl group and a heptyl group; aryl groups such as a phenyl group, a tolyl group, a xylyl group and a naphthyl group; aralkyl groups such as a benzyl group and a phenethyl group; and halogenated alkyl groups such as a chloromethyl group, a 3-chloropropyl group and a 3,3,3-trifluoropropyl group.

When the composition forming a silicone rubber layer contains a siloxane compound having three or more SiH groups in the molecule, the concentration of H groups derived from the SiH group is preferably 0.050 to 0.150% by mass in the total solid content. By adjusting the concentration of H groups derived from the SiH group to 0.050% by mass or more, hard domains mainly composed of reaction aggregates are easily formed, thus making it possible to further improve the printing durability and scratch resistance. The concentration of H groups derived from the SiH groups is more preferably 0.070% by mass or more. Meanwhile, by adjusting the concentration of H groups derived from the SiH groups to 0.150% by mass or less, it is possible to suppress deterioration of the image reproducibility and ink repellency. The concentration of H groups derived from the SiH groups is more preferably 0.130% by mass or less.

Examples of the silane coupling agent include methyltriacetoxysilane, ethyltriacetoxysilane, phenyltriacetoxysilane, toluyltriacetoxysilane, xylyltriacetoxysilane, methyltris(methylethylketoximino)silane, ethyltris(methylethylketoximino)silane, phenyltris(methylethylketoximino)silane, toluyltris(methylethylketoximino)silane, xylyltris(methylethylketoximino)silane, vinyltriacetoxysilane, allyltriacetoxysilane, 3-acryloxypropyltriacetoxysilane, 3-methacryloxypropyltriacetoxysilane, vinyltris(methylethylketoximino)silane, allyltris(methylethylketoximino)silane, 3-acryloxypropyltris(methylethylketoximino)silane, 3-methacryloxypropyltris(methylethylketoximino)silane and the like. Two or more thereof may be contained. Of these, vinyltriacetoxysilane or vinyltris(methylethylketoximino)silane is preferable.

When the silicone rubber layer-forming composition contains a silane coupling agent, the content thereof is preferably 8 to 38% by mass in the total solid content. By adjusting the content of the silane coupling agent to 8% by mass or more, hard domains are easily formed, thus making it possible to further improve the printing durability and scratch resistance. The content of the silane coupling agent is more preferably 15% by mass or more. Meanwhile, by adjusting the content of the silane coupling agent to 38% by mass or less, it is possible to suppress deterioration of the ink repellency. The content of the silane coupling agent is more preferably 30% by mass or less.

Next, a method for producing a printing plate from a printing plate precursor will be described. The method for producing a printing plate of the present invention preferably includes an exposure step of irradiating the above-mentioned printing plate precursor with laser light to form a latent image, and a development step of removing the silicone rubber layer corresponding to the image area of the latent image.

First, the exposure step will be described. When a cover film or an interleaving paper is provided on the silicone rubber layer of the printing plate precursor, it is preferable to remove in advance.

Examples of the method for exposing a printing plate precursor include a method (CTP) in which an image is directly written into a printing plate precursor using near-infrared laser light (wavelength: 800 to 1,500 nm) according to digital data without using an original film.

For forming a latent image in the exposure step, it is preferable to use an AM screen having a precision equivalent to an AM screen of 180 lpi to 650 lpi or an AM/FM mixed screen. If the accuracy is equivalent to or exceeds the 180 lpi equivalent of an AM screen, it is possible to suppress moire, line break, graininess and the like on the printed matter. Meanwhile, if the accuracy is equal to or less than the 650 lpi equivalent accuracy of the AM screen, it is possible to further improve the image reproducibility and to further suppress the printing unevenness. Examples of commercially available AM/FM mixed screen include Fairdot 2-350 and -650 (all of which are manufactured by SCREEN Graphic Solutions Co., Ltd.), Staccato-10, -20, -25, -35 and -36 (all of which are manufactured by Kodak Japan, Ltd.), and Sublima-190, -210, -240, -280, -300, -340 and -360 (all of which are manufactured by Agfa-Gevaert).

Next, the development step will be described.

The exposed planographic printing plate precursor is subjected to rubbing in the presence or absence of a liquid to remove either the exposed area or the unexposed area of the silicone rubber layer. When the heat sensitive layer provided on the printing plate precursor is any one of the above-mentioned thermally-soluble, thermally-expandable, thermally-ablatable and thermally-separable heat sensitive layers, the silicone rubber layer of the exposed area is removed. Meanwhile, when the heat sensitive layer is the thermally-curable heat sensitive layer, the silicone rubber layer of the unexposed area is removed. Examples of the method for performing a scrubbing treatment include: (i) a method in which a pad for development, a brush, a dry cotton pad or the like is used to scrub the precursor surface, in the absence of a liquid; (ii) a method in which a nonwoven fabric, an absorbent cotton, a cloth, a sponge or the like impregnated with water, or with water to which a surfactant is added, is used to wipe off the precursor surface; (iii) a method in which the precursor surface is scrubbed with a rotatable brush, while bringing the precursor surface into contact with water, or water to which a surfactant is added; and (iv) a method in which water, warm water or water vapor under high pressure is injected to the precursor surface. The surfactant is preferably one whose aqueous solution has a pH of from 5 to 8. The content of the surfactant is preferably 10% by mass or less with respect to the amount of the aqueous solution. Such an aqueous solution is preferable because of its high safety, and also in terms of economic efficiency such as the cost of disposal.

Before performing the development, a pre-treatment may be carried out in which the printing precursor is immersed in a pre-treatment solution for certain period of time. The pre-treatment solution may be, for example: water; water to which a polar solvent such as an alcohol, a ketone, an ester, or a carboxylic acid is added; a solvent composed of at least one of an aliphatic hydrocarbon, an aromatic hydrocarbon, and the like, to which a polar solvent is added; or a polar solvent. Of these, preferred is a pre-treatment solution containing a glycol compound or a glycol ether compound as a main component. Further, an amine compound, the above mentioned surfactant or the like may be added to the pre-treatment solution.

Examples of the pre-treatment solution include those disclosed in JP 63-179361 A, JP 4-163557 A, JP 4-343360 A, JP 9-34132 A, and WO 1997/017634 A1. Specific examples of the pre-treatment solution include PP-1, PP-3, PP-F, PP-FII, PTS-1, PH-7N, CP-1, NP-1, DP-1, CP-Y, CP-X and PX (all of which are manufactured by Toray Industries, Inc.).

For the purpose of enhancing the visibility of the image area and the accuracy of measuring halftone dots, it is possible to add a dye such as Crystal Violet, Victoria Pure Blue or Astrazon Red to water, or water to which a surfactant is added, so that the dyeing of an ink-receptive layer forming the image area can be carried out simultaneously with the development. Further, it is also possible to dye the ink-receptive layer of the image area after the exposure, using a liquid to which any of the above mentioned dyes is added.

A part or the entirety of the development step can be carried out automatically by an automatic developing machine. As the automatic developing machine, it is possible to use: an apparatus consisting of a development unit; an apparatus in which a pre-treatment unit and a development unit are provided in this order; an apparatus in which a pre-treatment unit, a development unit, and a after-treatment unit are provided in this order; an apparatus in which a pre-treatment unit, a development unit, a after-treatment unit, and a water-washing unit are provided in this order; or the like. Specific examples of such automatic developing machine include TWL-650 series, TWL-860 series, and TWL-1160 series (all of which are manufactured by Toray Industries, Inc.); and the automatic developing machines disclosed in JP 4-2265 A, JP 5-2272 A, JP 5-6000 A and the like. These automatic developing machines may be used in combination.

When the thus obtained planographic printing plates are stored in a stack, it is preferable to place an interleaving paper between the plates in order to protect the plate surfaces.

Next, a method for producing a printed matter will be described.

The method for producing a printed matter preferably uses the above-mentioned printing plate, ink and printing substrate. Specifically, the method preferably includes a step of applying an ink on the surface of the ink-receptive area of the planographic printing plate, and a step of transferring the ink applied on the surface of the ink-receptive area to the printing substrate directly or via a blanket.

It is possible to use, as the printing machine, a generally known direct printing machine or offset printing machine. An offset printing machine is preferable since it is possible to obtain a large amount of printed matters by suppressing the damage to the waterless planographic printing plate during printing. The offset printing machine is preferably an offset printing machine in which a rocking roller and/or a plate cylinder is/are provided with a cooling mechanism in view of improving the toning resistance.

It is possible to use, as the ink, a known oxidative polymerization type ink or an active energy ray-curing type ink. The active energy ray-curing type ink is preferable since it is quickly dried and can be transferred to the next step immediately after printing. The ink may be oil-soluble or water-soluble, but is preferably water-soluble in view of reducing the burden on workers and the environment. A water-soluble active energy ray-curing type ink is more preferable.

Examples of the water-soluble active energy ray-curing type ink to be preferably used in the present invention include known water-soluble active energy ray-curing type inks that can be washed with water or an aqueous washing liquid, as disclosed in JP 2017-52817 A, WO 2017/047817 A1, WO 2017/090663 A1 and the like.

Examples of the active energy ray include visible light, ultraviolet light (UV), electron beam (EB), X-ray, particle beam and the like. Of these, ultraviolet light and electron beam are preferable in view of ease of handling of the radiation source.

When the ink is cured by ultraviolet light, an ultraviolet ray irradiation device such as a high-pressure mercury lamp, a xenon lamp, a metal halide lamp or an LED is preferably used. For example, when using a metal halide lamp, it is preferable in view of the productivity to use a lamp having an illuminance of 80 to 150 W/cm² and to cure the ink while conveying the ink on a conveyor at a conveying speed of 50 to 150 m/min. In particular, when using a printing substrate including a plastic film or metal as the printing substrate, the heat generated by the active energy ray tends to cause the printing substrate to expand and contract, so that it is preferable to use electron beam that generates less heat, or an ultraviolet irradiation device using LEDs (LED-UV).

When curing is performed by electron beam, an electron beam irradiation device having energy beam of 100 to 500 eV is preferably used.

Examples of the printing substrate include papers such as fine paper, art paper, coated paper, cast paper, synthetic paper and newsprint; metals such as aluminum, aluminum alloys, iron, steel, zinc and copper; plastic films of polyethylene terephthalate, polyethylene, polyester, polyamide, polyimide, polystyrene, polypropylene, polycarbonate and polyvinyl acetal; and composites of these papers, metals and plastic films (paper or plastic film vapor-deposited or laminated with metal, paper or metal laminated with plastic film, metal or plastic film laminated with paper, etc.).

In particular, the method for producing a printed matter according to the present invention is suitable for printing on the printing substrate that do not absorb ink components, such as synthetic paper, metals, plastic films, paper or plastic film with metal vapor-deposited or laminated thereon, and paper or metal laminated with a plastic film, the printing surface of which is composed of metal or plastic film.

Of the above, the printing surface of the printing substrate, such as synthetic paper, plastic films, paper or metal laminated with a plastic film, may be made of a plastic film, and the printing surface may be subjected to a surface treatment such as coating of a primer resin, corona discharge treatment, or glow discharge treatment in order to improve the adhesion.

The printing substrate may be in either a sheet or roll form. When printing on a thin film for flexible packaging, it is preferable to use a rolled film and perform printing by a roll-to-roll method. By printing using a seamless printing plate with a cylindrical or columnar substrate and a rolled long printing substrate by the roll-to-roll method, it is possible to mass-produce high-definition printed matters with seamless picture patterns.

### EXAMPLES

Hereinafter, the present invention will be described in further detail by way of Examples. Evaluations in the respective Examples and Comparative Examples were carried out by the following methods.

### (1) Arithmetic Mean Roughness (Ra) of Substrate Surface

The arithmetic mean roughness (Ra) of the surface of the substrate used in the respective Examples and Comparative Examples was measured using a method in accordance with the Japanese Industrial Standard (JIS B 0601:2001). Specifically, Ra in the direction perpendicular to the rolling marks was measured using a surface roughness tester "Surfcom" (registered trademark) 1400G (manufactured by Tokyo Seimitsu Co., Ltd.).

### (2) Sum of Protrusion and Depression areas of Substrate

The printing plate precursors measuring 1,170 mm × 854 mm obtained in the respective Examples and Comparative Examples were cut into 30 samples measuring 10 mm × 10 mm such that a total of 30 locations, namely, 100, 133, 167, 200, 234, 267, 301, 334, 368, 401, 434, 468, 501, 535, 568, 602, 635, 669, 702, 736, 769, 802, 836, 869, 903, 936, 970, 1003, 1037 and 1070 mm from the widthwise edge of the printing plate precursor, were positioned approximately at the center of each sample. After cutting, each of 30 samples was embedded in a resin, and then a cross-section perpendicular to the rolling marks of the aluminum substrate was prepared by the BIB method and the observation surface was subjected to a conductive treatment (Pt coating) to fabricate a sample for cross-sectional observation. The sample for cross-section observation thus obtained is observed using a scanning electron microscope (SEM) under the following observation conditions.

### [Cross-Sectional SEM Observation]

Field-emission scanning electron microscope: SU8020
(manufactured by Hitachi High-Tech Corporation)
Observation conditions: Backscattered electron image
Acceleration voltage: 3.0 kV
Magnification: 5,000 times

In the thus obtained cross-sectional SEM images obtained at 30 locations, a line c0 representing the reference height of the substrate was drawn so as to be parallel to the line representing the interface between the silicone rubber layer and the embedding resin. The average height of the substrate was calculated by dividing the area of the substrate portion in each cross-sectional SEM image by the observation width of the cross-sectional SEM image. The average height of the thus obtained substrate was taken as the reference height from the base of the cross-sectional SEM image. In each cross-sectional SEM image, the sum of the protrusion and depression areas was calculated for a 25 µm width of the substrate located in the center of the width direction of the image, and the total values of the protrusion and depression areas for all 30 cross-sectional SEM images were added up, thereby making it possible to determine the sum of the protrusion and depression areas (sum of surface protrusion and depression areas).

### (3) Viscosity of Primer Layer-Forming Composition

The viscosity of the primer layer-forming composition obtained in the respective Examples and Comparative Examples was measured using a method in accordance with the Japanese Industrial Standard (JIS Z 8803:2011). Specifically, the composition was left to stand for 24 hours in a thermostatic chamber at 25°C equipped with a digital viscometer: DVNext (manufactured by EKO INSTRUMENTS CO., LTD.) to defoam the composition and adjust the liquid temperature to 25°C. The viscosity of the primer layer-forming composition after standing for 24 hours was measured three times using the digital viscometer, and the arithmetic mean value was taken as the viscosity of the primer layer-forming composition.

### (4) Sum of Protrusion and Depression areas of Primer Layer, and Number of Intersections

In the cross-sectional SEM image of the printing plate precursor obtained in the above item (2), a line a0 representing the reference height of the primer layer was drawn so as to be parallel to the line representing the interface between the silicone rubber layer and the embedding resin. The total reference height of the substrate and the primer layer was calculated by dividing the total area of the substrate portion and the primer layer portion in the cross-sectional SEM image by the observation width of each cross-sectional SEM image. The thus obtained total average height of the substrate and the primer layer was taken as the height from the base of the cross-sectional SEM image. In each cross-sectional SEM image, the sum of the protrusion and depression areas of the primer layer was calculated for a 25 µm width of the primer layer located in the center of the width direction of the image, and the total values of the protrusion and depression areas for all 30 cross-sectional SEM images were added up, thereby making it possible to determine the sum of the protrusion and depression areas (sum of surface protrusion and depression areas).

In each cross-sectional SEM image, the number of intersections between the reference height of the primer layer and the line representing the interface between the primer layer and the thermosensitive layer was counted, and the number of intersections was determined by adding up all the numbers of intersections for the 30 cross-sectional SEM images.

### (5) Average Thickness, Maximum Peak Height and Thinnest Portion Thickness of Primer Layer

After embedding each of the printing plate precursors obtained in the respective Examples and Comparative Examples in a resin, a cross-section perpendicular to the rolling marks of the aluminum substrate was prepared by the BIB method and the observation surface was subjected to a conductive treatment (Pt coating) to fabricate a sample for cross-sectional observation. From the obtained sample for cross-section observation, 30 points were randomly selected in the width direction and cross-sectional SEM observation was performed under the following conditions.

### [Cross-Sectional SEM Observation]

Field-emission scanning electron microscope: SU8020
(manufactured by Hitachi High-Tech Corporation)
Observation conditions: Backscattered electron image
Acceleration voltage: 3.0 kV
Magnification: 100 times to 30,000 times (selected appropriately depending on the thickness of the primer layer).

Of the 30 cross-sectional SEM images thus obtained, 20 randomly selected points were used to measure the thickness of the primer layer, and the arithmetic mean value was taken as the average thickness of the primer layer.

Of the cross-sectional SEM images of all 30 locations thus obtained, the thickness of the thinnest portion of the primer layer was measured, and this value was taken as the thickness of the thinnest portion of the primer layer.

In all of the 30 cross-sectional SEM images thus obtained, the total area of the substrate portion and the primer layer portion of the cross-sectional SEM image was divided by the observation width of the cross-sectional SEM image to calculate the average height of the total of the support and the primer layer, and the reference height of the primer layer was determined by taking the obtained average height as the height from the bottom side of the cross-sectional SEM image. The height from the reference height of the primer layer to the peak of the maximum protrusion of the primer layer in the cross-sectional SEM image was measured to determine the peak height on the surface of the primer layer, and the part with the highest peak height was taken as the maximum peak height on the surface of the primer layer.

### (6) Sum of Protrusion and Depression areas of Heat Sensitive Layer

In the cross-sectional SEM image of the printing plate precursor obtained in the above item (2), a line b0 representing the reference height of the heat sensitive layer was drawn so as to be parallel to the line representing the interface between the silicone rubber layer and the embedding resin. The total reference height of the substrate, the primer layer and the heat sensitive layer was calculated by dividing the total area of the primer layer portion, the primer layer portion and the heat sensitive layer portion by the observation width of each cross-sectional SEM image. The thus obtained total average height of the substrate, the primer layer and the heat sensitive layer was taken as the reference height of the heat sensitive layer from the base of the cross-sectional SEM image. In each cross-sectional SEM image, the sum of the protrusion and depression areas of the heat sensitive layer was calculated for a 25 µm width of the heat sensitive layer located in the center of the width direction of the image, and the total values of the protrusion and depression areas for all 30 cross-sectional SEM images were added up, thereby making it possible to determine the sum of the protrusion and depression areas (sum of surface protrusion and depression areas).

### (7) Average Thickness and Thickness of Thinnest Portion of Heat Sensitive Layer

Of the 30 cross-sectional SEM images obtained in the above item (5), 20 randomly selected points were used to measure the thickness of the heat sensitive layer, and the arithmetic mean value was taken as the average thickness of the heat sensitive layer.

Of the cross-sectional SEM images of all 30 locations thus obtained, the thickness of the thinnest portion of the heat sensitive layer was measured, and this value was taken as the thickness of the thinnest portion of the heat

### sensitive layer.

### (8) Average Thickness of Silicone Rubber Layer

Of the 30 cross-sectional SEM images obtained in the above item (5), 20 randomly selected points were used to measure the thickness of the silicone rubber layer, and the arithmetic mean value was taken as the average thickness of the silicone rubber layer.

### (9) Presence or Absence of Hard Domains in Silicone Rubber Layer

The presence or absence of hard domains in the silicone rubber layer of the printing plate precursor obtained by the method mentioned in the respective Examples and Comparative Examples was evaluated by the following analytical method.
Analytical equipment: Scanning probe microscope (SPM):
NanoScope V dimension Icon (manufactured by Bruker)
Probe: Silicon cantilever (spring constant = 6 N/m)
Tip curvature radius: 8 nm
Load: 5 to 20 nN
Scanning mode: Force volume (contact mode)
Scanning range: Any 25 µm² of the silicone rubber layer
(vertical: 5 µm × horizontal: 5 µm)
Measurement points within scanning range: 4,096 points
(vertical: 64 points × horizontal: 64 points)
Measurement environment: Room temperature, in air

When the elastic modulus at all measurement points (4,096 points) within the obtained scanning range is mapped and the whole is taken as 100 area%, if the proportion of island parts having a high elastic modulus of 100 MPa or more in sea parts having a low elastic modulus of 10 MPa or less is less than 0.5 area%, it is determined that no hard domain is contained, and if the proportion of island parts having a high elastic modulus of 100 MPa or more is 0.5 area% or more, it is determined that hard domains are contained.

### (10) Image Reproducibility

Each of the printing plate precursors measuring 1,170 mm × 854 mm obtained in the respective Examples and Comparative Examples was mounted on a laser exposure machine: PlateRite 8900N-E (manufactured by Dainippon Screen Mfg. Co., Ltd.) and exposed to the halftone dot image (AM screen of 175 lpi (resolution: 2,400 dpi)) mentioned below in an area of 1,070 mm × 840 mm under the condition of exposure amount: 150 mJ/cm², and then developed under the developing conditions mentioned below to obtain printing plates.

### <Halftone Dot image>

Image pattern: 25 types of halftone dot patterns with dot area coverage of 0, 0.5, 1, 2, 3, 4, 5, 6, 7, 8, 9, 10, 15, 20, 25, 30, 35, 40, 45, 50, 60, 70, 80, 90 and 100%. Exposure area of each halftone dot: width is 1,070 mm for all, length is 120 mm for 0% halftone dot only, and 30 mm for 0.5 to 100% halftone dot.

### <Development Conditions>

### (Examples 1 to 12 and 14 to 24, and Comparative Examples 1 to 9)

Automatic developing machine: TWL-1160FII (manufactured by Toray Industries, Inc.)
Pre-treatment solution: CP-Y (manufactured by Toray
Industries, Inc., liquid temperature: 45°C)
Developer: tap water (liquid temperature: 30°C)
After-treatment liquid: PA-1 (liquid temperature: 30°C)
Water-washing: tap water (liquid temperature: 30°C)
Development speed: 60 cm/min

### (Example 13, Example 25, Example 26, Example 27 and Comparative Example 10)

Automatic developing machine: TWL-1160FII (manufactured by Toray Industries, Inc.)
Pre-treatment solution: None
Developer: tap water (liquid temperature: 30°C)
After-treatment liquid: None
Water-washing: tap water (liquid temperature: 30°C)
Development speed: 60 cm/min

The halftone dot image portion of the thus obtained printing plate was observed using a loupe at a magnification of 25 times, and the minimum dot area coverage at which no development defects occurred was evaluated as image reproducibility. The smaller the dot area coverage, the better the image reproducibility.

### (11) Printing Unevenness

Printing plates were obtained under the exposure and development conditions mentioned in the above item (10), except that the following four types of screens were used to form latent images in the exposure step.

### <Screen Type>

AM screen-1: AM screen of 175 lpi (resolution: 2,400 dpi)
AM screen-2: AM screen of 210 lpi (resolution: 2,400 dpi)
AM/FM mixed screen-1: Fairdot2-350 (equivalent to AM screen of 350 lpi, resolution: 2,400 dpi)
AM/FM mixed screen-2: Fairdot2-650 (equivalent to AM screen of 650 lpi, resolution: 2,400 dpi).

The printing plate thus obtained was attached to the plate cylinder of an EB offset printing machine: OFFSET CI/8 (manufactured by COMEXI), and printing was carried out under the following printing conditions/ink curing conditions, and then the presence or absence of the printing unevenness on each printed matter was visually evaluated. Print unevenness is suppressed to the extent that it is not noticeable even on a screen with equivalent higher precision.

### <Printing conditions>

Ink roller: #8000 (manufactured by Meiwa Rubber Co., Ltd.)
Blanket: MC1300 (manufactured by Kinyosha Co., Ltd.)
Water-soluble EB ink: Offset EB ink F type FE1908 Red (manufactured by Mitsuboshi Printing Ink Co.)
Printing medium that does not absorb ink components: "EMBLET" (registered trademark) PTM-12 (rolled biaxially oriented PET film, thickness: 12 µm, printing surface: easy-adhesion treatment, manufactured by Unitika Ltd.)
Plate surface temperature: 28±2°C
Printing speed: 150 m/min
Reflection density of solid areas: 1.50 ± 0.05

### <Ink curing conditions>

EB exposure dose: 40 kGy
EB exposure atmosphere: Nitrogen atmosphere

### (12) Ink Repellency

The print matter obtained in the above item (11) was cut out at approximately 500 m from the start of printing and placed on top of five sheets of coated paper: OK "Top Coat" (registered trademark) + (manufactured by Oji Paper Co., Ltd.). The reflection density of the solid white area (corresponding to the area with a dot area coverage of 0%) was measured using a spectrodensitometer/colorimeter: Exact Advance (manufactured by X-Rite Corporation). The lower the reflection density, the better the ink repellency.

### (13) Printing Durability

The printing plate obtained in the above item (10) was attached to the plate cylinder of an EB offset printing machine: OFFSET CI/8 (manufactured by COMEXI), printing was carried out under the printing conditions/ink curing conditions mentioned in the above (11), and the printed matter was sampled every 5,000 m. The presence or absence of toning, which is the formation of unintended printing lines in non-image areas, that is, printing areas corresponding to the portion of 0% dot area coverage (1,070 mm × 120 mm) of the printing plate, was observed. The limit of printing length at which toning was not observed was evaluated as printing durability. The longer the limit printing length, the better the printing durability.

### [Example 1]

An aluminum alloy plate having a thickness of 0.24 mm and an arithmetic mean surface roughness (Ra): 0.18 µm was used as a substrate. The following primer layer-forming composition-1 was applied on the substrate using a slit die coater (manufactured by Toray Engineering Co., Ltd.) so that the average film mass after heating would be 8.0 g/m², and the substrate was heated at 180°C for 2 minutes to provide a primer layer having an average film mass of 8.0 g/m².

### <Primer Layer-Forming Composition-1>

(a) Epoxy resin: "jER (registered trademark)" 1010 (manufactured by Mitsubishi Chemical Corporation, solids concentration: 100% by mass): 18 parts by mass
(b) Polyurethane: "SANPRENE (registered trademark)" LQ-T1331D (manufactured by Sanyo Chemical Industries, Ltd., N,N-dimethylformamide/2-ethoxyethanol solution (solids concentration: 20% by mass): 285 parts by mass (polyurethane: 57 parts by mass)
(c) Aluminum tris(ethyl acetoacetate): Alumichelate ALCH-TR (manufactured by Kawaken Fine Chemicals Co., Ltd., solids concentration: 100% by mass): 4 parts by mass
(d) Vinyl-based polymer: "DISPARLON (registered trademark)" LC951 (manufactured by Kusumoto Chemical Co., Ltd., thinner solution (solids concentration: 10% by mass): 0.1 part by mass
(e) The following titanium oxide dispersion (N,N-dimethylformamide dispersion (solids concentration: 50% by mass): 42 parts by mass (titanium oxide: 21 parts by mass)
(f) N,N-Dimethylformamide: 1,445 parts by mass
(g) Methyl ethyl ketone: 1,540 parts by mass

### <Preparation of Titanium Oxide Dispersion>

50 Parts by mass of titanium oxide "CR-50 (manufactured by Ishihara Sangyo Kaisha, Ltd.) was added to 50 parts by mass of N,N-dimethylformamide, followed by stirring for 5 minutes. Further, 75 parts by mass of glass beads (No. 08) were added and vigorously stirred for 20 minutes, and then the glass beads were removed to obtain a titanium oxide dispersion.

The following heat sensitive layer-forming composition-1 was applied on the primer layer using a slit die coater and heated at 150°C for 80 seconds to provide a thermally-soluble heat sensitive layer having an average film mass of 1.5 g/m².

### <Heat Sensitive Layer-Forming Composition-1>

(a) Near-infrared absorbing dye: PROJET 825LDI (manufactured by Avecia Limited., solids concentration: 100% by mass): 10 parts by mass
(b) Titanium di-n-butoxide bis(2,4-pentanedionate): "NACEM (registered trademark)" titanium (manufactured by Nippon Kagaku Sangyo Co., Ltd., titanium concentration: 8.8% by mass, n-butanol solution (solids concentration: 73% by mass): 22 parts by mass
(c) Phenol novolak resin: "SUMILITERESIN (registered trademark)" PR54652 (manufactured by Sumitomo Durez Co., Ltd., solids concentration: 100% by mass): 60 parts by mass
(d) "SANPRENE (registered trademark)" LQ-T1331D: 50 parts by mass
(e) 3-Glycidoxypropyltrimethoxysilane: 15 parts by mass
(f) Tetrahydrofuran: 668 parts by mass
(g) Ethanol: 40 parts by mass

The following silicone rubber layer-forming composition was applied on the heat sensitive layer using a slit die coater, and heated at 125°C for 80 seconds to provide a silicone rubber layer having an average film mass of 2.0 g/m², thereby obtaining a printing plate precursor. The concentration of H groups derived from SiH groups in the total solid content in the silicone rubber layer-forming composition was 0.013% by mass.

### <Silicone Rubber Layer-Forming Composition>

(a) α,ω-Divinylpolydimethylsiloxane: DMS-V52 (weight-average molecular weight of 110,000, manufactured by GELEST Inc., solids concentration: 100% by mass): 100 parts by mass
(b) Trimethylsilyl-both-terminated methylhydrogenpolysiloxane/dimethylsiloxane copolymer: HMS-151 (mol% of MeHSiO: 15 to 18%, GELEST Inc., solids concentration: 100% by mass): 7 parts by mass
(c) Vinyltris(methylethylketoximino)silane: 3 parts by mass
(d) Platinum catalyst: SRX-212 (manufactured by Dow Corning Toray Silicone Co., Ltd., solids concentration: 85.6% by mass): 5 parts by mass
(e) "Isopar (registered trademark)" E (manufactured by Esso Chemical Co., Ltd.): 1,035 parts by weight

### [Example 2]

In the same manner as in Example 1, except that the primer layer-forming composition-1 was changed to the following primer layer-forming composition-2, a printing plate precursor was obtained.

### <Primer Layer-Forming Composition-2>

(a) jER (registered trademark) 1010: 16 parts by mass
(b) Polyurethane: SANPRENE (registered trademark) LQ-SZ18D (manufactured by Sanyo Chemical Industries, Ltd., N,N-dimethylformamide solution (solids concentration: 15% by mass)): 480 parts by mass (polyurethane: 72 parts by mass)
(c) "Alumichelate" ALCH-TR: 4 parts by mass
(d) DISPARLON (registered trademark) LC951: 0.1 part by mass
(e) Titanium oxide dispersion: 16 parts by mass
(f) N,N-Dimethylformamide: 2,818 parts by mass

### [Example 3]

In the same manner as in Example 1, except that the primer layer-forming composition-1 was changed to the following primer layer-forming composition-3, a printing plate precursor was obtained.

### <Primer Layer-Forming Composition-3>

(a) jER (registered trademark) 1010: 28 parts by mass
(b) SANPRENE (registered trademark) LQ-T1331D: 160 parts by mass
(c) "Alumichelate" ALCH-TR: 6 parts by mass
(d) DISPARLON (registered trademark) LC951: 0.1 part by mass
(e) Titanium oxide dispersion: 68 parts by mass
(f) N,N-Dimethylformamide: 2,102 parts by mass
(g) Methyl ethyl ketone: 969 parts by mass

### [Example 4]

In the same manner as in Example 1, except that the primer layer-forming composition-1 was changed to the following primer layer-forming composition-4, a printing plate precursor was obtained.

### <Primer Layer-Forming Composition-4>

(a) "jER (registered trademark)" 1010: 36 parts by mass
(b) "SANPRENE (registered trademark)" LQ-T1331D: 110 parts by mass
(c) "Alumichelate" ALCH-TR: 8 parts by mass
(d) "DISPARLON (registered trademark)" LC951: 0.1 part by mass
(e) Titanium oxide dispersion: 68 parts by mass
(f) N,N-Dimethylformamide: 2,142 parts by mass
(g) Methyl ethyl ketone: 969 parts by mass

### [Example 5]

In the same manner as in Example 1, except that the primer layer-forming composition-1 was changed to the following primer layer-forming composition-5, a printing plate precursor was obtained.

### <Primer Layer-Forming Composition-5>

(a) "jER (registered trademark)" 1010: 46 parts by mass
(b) "SANPRENE (registered trademark)" LQ-T1331D: 50 parts by mass
(c) "Alumichelate" ALCH-TR: 10 parts by mass
(d) "DISPARLON (registered trademark)" LC951: 0.1 part by mass
(e) Titanium oxide dispersion: 68 parts by mass
(f) N,N-Dimethylformamide: 2,190 parts by mass
(g) Methyl ethyl ketone: 969 parts by mass

### [Example 6]

In the same manner as in Example 1, except that the primer layer-forming composition-1 was changed to the following primer layer-forming composition-6, a printing plate precursor was obtained.

### <Primer Layer-Forming Composition-6>

(a) "jER (registered trademark)" 1010: 41 parts by mass
(b) "SANPRENE (registered trademark)" LQ-T1331D: 235 parts by mass
(c) "Alumichelate" ALCH-TR: 9 parts by mass
(d) "DISPARLON (registered trademark)" LC951: 0.1 part by mass
(e) Titanium oxide dispersion: 6 parts by mass
(f) N,N-Dimethylformamide: 2,073 parts by mass
(g) Methyl ethyl ketone: 969 parts by mass

### [Example 7]

In the same manner as in Example 1, except that the primer layer-forming composition-1 was applied so that the average film mass after heating would be 3.5 g/m², and a primer layer having an average film mass of 3.5 g/m² was provided, a printing plate precursor was obtained.

### [Example 8]

In the same manner as in Example 1, except that the primer layer-forming composition-1 was applied so that the average film mass after heating would be 5.0 g/m², and a primer layer having an average film mass of 5.0 g/m² was provided, a printing plate precursor was obtained.

### [Example 9]

In the same manner as in Example 1, except that the primer layer-forming composition-1 was applied so that the average film mass after heating would be 11.0 g/m², and a primer layer having an average film mass of 11.0 g/m² was provided, a printing plate precursor was obtained.

### [Example 10]

In the same manner as in Example 5, except that the primer layer-forming composition-5 was applied so that the average film mass after heating would be 500.0 g/m², and a primer layer having an average film mass of 500.0 g/m² was provided, a printing plate precursor was obtained.

### [Example 11]

In the same manner as in Example 5, except that the primer layer-forming composition-5 was applied so that the average film mass after heating would be 700.0 g/m², and a primer layer having an average film mass of 700.0 g/m² was provided, a printing plate precursor was obtained.

### [Example 12]

In the same manner as in Example 5, except that the primer layer-forming composition-5 was applied so that the average film mass after heating would be 900.0 g/m², a printing plate precursor was obtained. Dripping occurred during coating of the primer layer-forming composition, and the average film mass of the primer layer was 808.0 g/m².

### [Example 13]

In the same manner as in Example 9, except that the heat sensitive layer-forming composition-1 was changed to the following heat sensitive layer-forming composition-2, and the average film mass of the heat sensitive layer was changed to 1.8 g/m², a printing plate precursor was obtained. The heat sensitive layer thus obtained is a thermally-ablatable heat sensitive layer.

### <Heat Sensitive Layer-Forming Composition-2>

(a) Methylated melamine resin: "CYMEL (registered trademark)" 303: 50.16 parts by mass
(b) Blue pigment: Victoria Blue BO Dye: 0.69 part by mass
(c) Phosphate ester: "Lubrizol (registered trademark)" 2062: 0.50 part by mass
(d) Near-infrared absorbing dye: S009 NIR Dye: 28.09 parts by mass
(e) p-Toluenesulfonic acid catalyst: "Cycat (registered trademark)" 4040: 4.20 parts by mass
(f) Surfactant: "BYK" 307: 1.31 parts by mass
(g) Nitrocellulose resin: "Walsroder (registered trademark)" E400 NC: 15.05 parts by mass
(h) 1-Methoxypropan-2-ol: 550.00 parts by mass
(i) N-Methyl-2-pyrrolidone: 129.00 parts by mass

### [Example 14]

In the same manner as in Example 8, except for changing to an aluminum alloy plate having a surface arithmetic mean roughness (Ra) of 0.27 µm, a printing plate precursor was obtained.

### [Example 15]

In the same manner as in Example 8, except for changing to an aluminum alloy plate having a surface arithmetic mean roughness (Ra) of 0.39 µm, a printing plate precursor was obtained.

### [Example 16]

In the same manner as in Example 11, except that the primer layer forming composition-5 was changed to the following primer layer forming composition-7, a printing plate precursor was obtained. Dripping occurred during coating of the primer layer-forming composition, and the average film mass of the primer layer was 628.5 g/m².

### <Primer Layer-Forming Composition-7>

(a) "jER (registered trademark)" 1010: 46 parts by mass
(b) "SANPRENE (registered trademark)" LQ-T1331D: 50 parts by mass
(c) Alumichelate ALCH-TR: 10 parts by mass
(d) "DISPARLON (registered trademark)" LC951: 0.1 part by mass
(e) Titanium oxide dispersion: 68 parts by mass
(f) N,N-Dimethylformamide: 6,857 parts by mass
(g) Methyl ethyl ketone: 2,970 parts by mass

### [Example 17]

In the same manner as in Example 2, except that the primer layer forming composition-2 was changed to the following primer layer forming composition-8, a printing plate precursor was obtained.

### <Primer Layer-Forming Composition-8>

(a) "jER (registered trademark)" 1010: 16 parts by mass
(b) "SANPRENE (registered trademark)" LQ-SZ18D: 480 parts by mass
(c) Alumichelate ALCH-TR: 4 parts by mass
(d) "DISPARLON (registered trademark)" LC951: 0.1 part by mass
(e) Titanium oxide dispersion: 16 parts by mass
(f) N,N-Dimethylformamide: 914 parts by mass
(g) Methyl ethyl ketone: 570 parts by mass

### [Example 18]

In the same manner as in Example 9, except that the average film mass of the silicone rubber layer was changed to 3.4 g/m², a printing plate precursor was obtained.

### [Example 19]

In the same manner as in Example 9, except that the average film mass of the silicone rubber layer was changed to 4.4 g/m², a printing plate precursor was obtained.

### [Example 20]

In the same manner as in Example 9, except that the average film mass of the silicone rubber layer was changed to 5.0 g/m², a printing plate precursor was obtained.

### [Example 21]

Tn the same manner as in Example 9, except that 7 parts by mass of (b) HMS-151 of the silicone rubber layer-forming composition was changed to 4 parts by mass of (b) trimethylsilyl-both-terminated methylhydrogenpolysiloxane: HMS-991 (mol% of MeHSiO: 100%, GELEST Inc., solids concentration: 100% by mass), a printing plate precursor was obtained. The concentration of H groups derived from SiH groups in the total solid content in the silicone rubber layer forming composition was 0.054% by mass.

### [Example 22]

In the same manner as in Example 21, except that the amount of (b) HMS-991 of the silicone rubber layer-forming composition was changed to 5.5 parts by mass, a printing plate precursor was obtained. The concentration of H groups derived from SiH groups in the total solid content in the silicone rubber layer forming composition was 0.073% by mass.

### [Example 23]

In the same manner as in Example 21, except that the amount of (b) HMS-991 of the silicone rubber layer-forming composition was changed to 10 parts by mass, a printing plate precursor was obtained. The concentration of H groups derived from SiH groups in the total solid content in the silicone rubber layer forming composition was 0.127% by mass.

### [Example 24]

In the same manner as in Example 21, except that the amount of (b) HMS-991 of the silicone rubber layer-forming composition was changed to 11.5 parts by mass, a printing plate precursor was obtained. The concentration of H groups derived from SiH groups in the total solid content in the silicone rubber layer forming composition was 0.145% by mass.

### [Example 25]

In the same manner as in Example 13, except that the primer layer-forming composition-1 was applied so that the average film mass after heating would be 3.5 g/m², and a primer layer having an average film mass of 3.5 g/m² was provided, a printing plate precursor was obtained.

### [Example 26]

In the same manner as in Example 13, except that the primer layer-forming composition-1 was applied so that the average film mass after heating would be 5.0 g/m², and a primer layer having an average film mass of 5.0 g/m² was provided, a printing plate precursor was obtained.

### [Example 27]

In the same manner as in Example 13, except that the primer layer-forming composition-1 was applied so that the average film mass after heating would be 8.0 g/m², and a primer layer having an average film mass of 8.0 g/m² was provided, a printing plate precursor was obtained.

### [Comparative Example 1]

In the same manner as in Example 1, except that the primer layer-forming composition-1 was changed to the following primer layer-forming composition-9, a printing plate precursor was obtained.

### <Primer Layer-Forming Composition-9>

(a) "jER (registered trademark)" 1010: 18 parts by mass
(b) "SANPRENE (registered trademark)" LQ-T1331D: 285 parts by mass
(c) Alumichelate ALCH-TR: 4 parts by mass
(d) "DISPARLON (registered trademark)" LC951: 0.1 part by mass
(e) Titanium oxide dispersion: 42 parts by mass
(f) N,N-Dimethylformamide: 48 parts by mass
(g) Methyl ethyl ketone: 270 parts by mass

### [Comparative Example 2]

In the same manner as in Example 2, except that the primer layer-forming composition-2 was changed to the following primer layer-forming composition-10, a printing plate precursor was obtained.

### <Primer Layer-Forming Composition-10>

(a) "jER (registered trademark)" 1010: 16 parts by mass
(b) "SANPRENE (registered trademark)" LQ-SZ18D: 480 parts by mass
(c) Alumichelate ALCH-TR: 4 parts by mass
(d) "DISPARLON (registered trademark)" LC951: 0.1 part by mass
(e) Titanium oxide dispersion: 16 parts by mass
(f) N,N-Dimethylformamide: 151 parts by mass

### [Comparative Example 3]

In the same manner as in Example 2, except that the primer layer-forming composition-2 was changed to the following primer layer-forming composition-11, a printing plate precursor was obtained.

<Primer Layer-Forming Composition-11>
(a) "jER (registered trademark)" 1010: 16 parts by mass
(b) "SANPRENE (registered trademark) "LQ-SZ18D: 480 parts by mass
(c) Alumichelate ALCH-TR: 4 parts by mass
(d) "DISPARLON (registered trademark)" LC951: 0.1 part by mass
(e) Titanium oxide dispersion: 16 parts by mass
(f) N,N-Dimethylformamide: 514 parts by mass
(g) Methyl ethyl ketone: 399 parts by mass

### [Comparative Example 4]

In the same manner as in Example 3, except that the primer layer-forming composition-3 was changed to the following primer layer-forming composition-12, a printing plate precursor was obtained.

### <Primer Layer-Forming Composition-12>

(a) "jER (registered trademark)" 1010: 28 parts by mass
(b) "SANPRENE (registered trademark)" LQ-T1331D: 160 parts by mass
(c) Alumichelate ALCH-TR: 6 parts by mass
(d) "DISPARLON (registered trademark)" LC951: 0.1 part by mass
(e) Titanium oxide dispersion: 68 parts by mass
(f) N,N-Dimethylformamide: 235 parts by mass
(g) Methyl ethyl ketone: 170 parts by mass

### [Comparative Example 5]

In the same manner as in Example 4, except that the primer layer-forming composition-4 was changed to the following primer layer-forming composition-13, a printing plate precursor was obtained.

### <Primer Layer-Forming Composition-13>

(a) "jER (registered trademark)" 1010: 36 parts by mass
(b) "SANPRENE (registered trademark)" LQ-T1331D: 110 parts by mass
(c) Alumichelate ALCH-TR: 8 parts by mass
(d) "DISPARLON (registered trademark)" LC951: 0.1 part by mass
(e) Titanium oxide dispersion: 68 parts by mass
(f) N,N-Dimethylformamide: 275 parts by mass
(g) Methyl ethyl ketone: 170 parts by mass

### [Comparative Example 6]

In the same manner as in Example 5, except that the primer layer-forming composition-5 was changed to the following primer layer-forming composition-14, a printing plate precursor was obtained.

### <Primer Layer-Forming Composition-14>

(a) "jER (registered trademark)" 1010: 46 parts by mass
(b) "SANPRENE (registered trademark)" LQ-T1331D: 50 parts by mass
(c) Alumichelate ALCH-TR: 10 parts by mass
(d) "DISPARLON (registered trademark)" LC951: 0.1 part by mass
(e) Titanium oxide dispersion: 68 parts by mass
(f) N,N-Dimethylformamide: 323 parts by mass
(g) Methyl ethyl ketone: 170 parts by mass

### [Comparative Example 7]

In the same manner as in Example 6, except that the primer layer-forming composition-6 was changed to the following primer layer-forming composition-15, a printing plate precursor was obtained.

### <Primer Layer-Forming Composition-15>

(a) "jER (registered trademark)" 1010: 41 parts by mass
(b) "SANPRENE (registered trademark)" LQ-T1331D: 235 parts by mass
(c) Alumichelate ALCH-TR: 9 parts by mass
(d) "DISPARLON (registered trademark)" LC951: 0.1 part by mass
(e) Titanium oxide dispersion: 6 parts by mass
(f) N,N-Dimethylformamide: 206 parts by mass
(g) Methyl ethyl ketone: 170 parts by mass

### [Comparative Example 8]

In the same manner as in Comparative Example 2, except that primer layer-forming composition-10 was applied so that the average film mass after heating would be 16.0 g/m², and a primer layer having an average film mass of 16.0 g/m² was provided, a printing plate precursor was obtained.

### [Comparative Example 9]

In the same manner as in Comparative Example 7, except that primer layer-forming composition-15 was applied so that the average film mass after heating would be 16.0 g/m², and a primer layer having an average film mass of 16.0 g/m² was provided, a printing plate precursor was obtained.

### [Comparative Example 10]

In the same manner as in Comparative Example 1, except that primer layer-forming composition-9 was applied so that the average film mass after heating would be 11.0 g/m², and a primer layer having an average film mass of 16.0 g/m² was provided, and that the heat sensitive layer-forming composition-1 was changed to the heat sensitive layer-forming composition-2 and the average film mass of the heat sensitive layer was changed to 1.8 g/m², a printing plate precursor was obtained.

The evaluation results for Examples 1 to 27 and Comparative Examples 1 to 10 are shown in Tables 1 to 4.

**[Table 1]**

| No. | Substrate | | Primer layer | | | | | | | Heat sensitive layer | | | Silicone rubber layer | |
|---|---|---|---|---|---|---|---|---|---|---|---|---|---|---|
| | Arithmetic mean roughness (Ra) [µm] | Sum of surface protrusion and depression areas [µm²] | Composition | | Layer | | | | | Layer | | | Layer | |
| | | | Solids concentration [% by weight] | Viscosity [mPa·s] | Average thickness [µm] | Maximum peak height [µm] | Sum of surface protrusion and depression areas [µm²] | Number of intersections | Thinnest portion thickness [µm] | Average thickness [µm] | Sum of surface protrusion and depressio n areas [µm²] | Thinnest portion thickness [µm] | Average thickness [µm] | Presence or absence of hard domains |
| Example 1 | 0.18 | 154 | 3.0 | 34 | 5.3 | 0.15 | 18 | 240 | 4.0 | 1.19 | 9 | 1.04 | 2.1 | None |
| Example 2 | 0.18 | 154 | 3.0 | 48 | 5.8 | 0.15 | 18 | 240 | 4.5 | 1.19 | 9 | 1.04 | 2.1 | None |
| Example 3 | 0.18 | 154 | 3.0 | 22 | 4.6 | 0.19 | 23 | 240 | 3.3 | 1.19 | 12 | 1.00 | 2.1 | None |
| Example 4 | 0.18 | 154 | 3.0 | 14 | 4.5 | 0.18 | 22 | 240 | 3.2 | 1.19 | 11 | 1.01 | 2.1 | None |
| Example 5 | 0.18 | 154 | 3.0 | 6 | 4.4 | 0.16 | 19 | 240 | 3.1 | 1.19 | 10 | 1.03 | 2.1 | None |
| Example 6 | 0.18 | 154 | 3.0 | 40 | 5.9 | 0.11 | 13 | 240 | 4.6 | 1.19 | 7 | 1.08 | 2.1 | None |
| Example 7 | 0.18 | 154 | 3.0 | 34 | 2.3 | 0.45 | 54 | 240 | 1.0 | 1.19 | 27 | 0.74 | 2.1 | None |
| Example 8 | 0.18 | 154 | 3.0 | 34 | 3.3 | 0.34 | 42 | 240 | 2.0 | 1.19 | 21 | 0.84 | 2.1 | None |
| Example 9 | 0.18 | 154 | 3.0 | 34 | 7.3 | 0.05 | 6 | 240 | 6.0 | 1.19 | 3 | 1.14 | 2.1 | None |
| Example 10 | 0.18 | 154 | 3.0 | 6 | 280 | 0.05 | 6 | 240 | 280 | 1.19 | 3 | 1.14 | 2.1 | None |
| Example 11 | 0.18 | 154 | 3.0 | 6 | 390 | 0.31 | 37 | 240 | 390 | 1.19 | 19 | 0.86 | 2.1 | None |
| Example 12 | 0.18 | 154 | 3.0 | 6 | 450 | 0.48 | 58 | 240 | 450 | 1.19 | 29 | 0.71 | 2.1 | None |
| Example 13 | 0.18 | 154 | 3.0 | 34 | 7.3 | 0.05 | 6 | 240 | 6.0 | 1.24 | 3 | 1.19 | 2.1 | None |
| Example 14 | 0.27 | 203 | 3.0 | 34 | 3.3 | 0.39 | 48 | 360 | 1.8 | 1.19 | 24 | 0.76 | 2.1 | None |
| Example 15 | 0.39 | 293 | 3.0 | 34 | 3.3 | 0.49 | 59 | 520 | 1.7 | 1.19 | 30 | 0.69 | 2.1 | None |
| Example 16 | 0.18 | 154 | 1.0 | 3 | 350 | 0.47 | 56 | 240 | 350.0 | 1.19 | 28 | 0.70 | 2.1 | None |
| Example 17 | 0.18 | 154 | 5.0 | 92 | 5.8 | 0.46 | 55 | 240 | 4.8 | 1.19 | 28 | 0.66 | 2.1 | None |
| Example 18 | 0.18 | 154 | 3.0 | 34 | 7.3 | 0.05 | 6 | 240 | 6.0 | 1.19 | 3 | 1.14 | 3.5 | None |
| Example 19 | 0.18 | 154 | 3.0 | 34 | 7.3 | 0.05 | 6 | 240 | 6.0 | 1.19 | 3 | 1.14 | 4.5 | None |
| Example 20 | 0.18 | 154 | 3.0 | 34 | 7.3 | 0.05 | 6 | 240 | 6.0 | 1.19 | 3 | 1.14 | 5.2 | None |
| Example 21 | 0.18 | 154 | 3.0 | 34 | 7.3 | 0.05 | 6 | 240 | 6.0 | 1.19 | 3 | 1.14 | 2.1 | Observed |
| Example 22 | 0.18 | 154 | 3.0 | 34 | 7.3 | 0.05 | 6 | 240 | 6.0 | 1.19 | 3 | 1.14 | 2.1 | Observed |
| Example 23 | 0.18 | 154 | 3.0 | 34 | 7.3 | 0.05 | 6 | 240 | 6.0 | 1.19 | 3 | 1.14 | 2.1 | Observed |
| Example 24 | 0.18 | 154 | 3.0 | 34 | 7.3 | 0.05 | 6 | 240 | 6.0 | 1.19 | 3 | 1.14 | 2.1 | Observed |
| Example 25 | 0.18 | 154 | 3.0 | 34 | 2.3 | 0.45 | 54 | 240 | 1.0 | 1.24 | 27 | 0.78 | 2.1 | None |
| Example 26 | 0.18 | 154 | 3.0 | 34 | 3.3 | 0.34 | 42 | 240 | 2.0 | 1.24 | 21 | 0.88 | 2.1 | None |
| Example 27 | 0.18 | 154 | 3.0 | 34 | 5.3 | 0.15 | 18 | 240 | 4.0 | 1.24 | 9 | 1.09 | 2.1 | None |

**[Table 2]**

| No. | Dripping of primer layer-forming composition during coating | Image reproducibility [halftone dot%] | Printing unevenness | | | | Ink repellency | Printing durability [10,000 m] |
|---|---|---|---|---|---|---|---|---|
| | | | AM screen | | AM/FM mixed screen | | | |
| | | | 1 175 lpi | 2 210 lpi | 1 Equivalent to 350 lpi | 2 Equivalent to 650 lpi | | |
| Example 1 | None | 0.5 | None | None | None | None | 0.02 | 11.0 |
| Example 2 | None | 0.5 | None | None | None | None | 0.02 | 11.0 |
| Example 3 | None | 0.5 | None | None | None | None | 0.02 | 11.0 |
| Example 4 | None | 0.5 | None | None | None | None | 0.02 | 11.0 |
| Example 5 | None | 0.5 | None | None | None | None | 0.02 | 11.0 |
| Example 6 | None | 0.5 | None | None | None | None | 0.02 | 11.0 |
| Example 7 | None | 1 | None | None | None | Observed | 0.02 | 9.5 |
| Example 8 | None | 0.5 | None | None | None | None | 0.02 | 10.0 |
| Example 9 | None | 0.5 | None | None | None | None | 0.02 | 11.5 |
| Example 10 | None | 0.5 | None | None | None | None | 0.02 | 11.5 |
| Example 11 | None | 0.5 | None | None | None | None | 0.02 | 10.0 |
| Example 12 | Observed | 1 | None | None | None | Observed | 0.02 | 9.5 |
| Example 13 | None | 0.5 | None | None | None | None | 0.02 | 11.5 |
| Example 14 | None | 0.5 | None | None | None | Observed | 0.02 | 10.0 |
| Example 15 | None | 1 | None | None | None | Observed | 0.02 | 9.5 |
| Example 16 | Observed | 1 | None | None | None | Observed | 0.02 | 9.5 |
| Example 17 | None | 1 | None | None | None | Observed | 0.02 | 9.5 |
| Example 18 | None | 0.5 | None | None | None | None | 0.00 | 12.0 |
| Example 19 | None | 0.5 | None | None | None | None | 0.00 | 12.5 |
| Example 20 | None | 1 | None | None | None | Observed | 0.00 | 13.0 |
| Example 21 | None | 0.5 | None | None | None | None | 0.02 | 12.0 |
| Example 22 | None | 0.5 | None | None | None | None | 0.02 | 12.5 |
| Example 23 | None | 0.5 | None | None | None | None | 0.02 | 13.0 |
| Example 24 | None | 1 | None | None | None | Observed | 0.04 | 13.5 |
| Example 25 | None | 1 | None | None | None | Observed | 0.02 | 9.5 |
| Example 26 | None | 0.5 | None | None | None | None | 0.02 | 10.0 |
| Example 27 | None | 0.5 | None | None | None | None | 0.02 | 11.0 |

**[Table 3]**

| No. | Substrate | | Primer layer | | | | | | | Heat sensitive layer | | | Silicone rubber layer | |
|---|---|---|---|---|---|---|---|---|---|---|---|---|---|---|
| | Arithmetic mean roughness (Ra) [um] | Sum of surface protrusion and depression areas [um²] | Composition | | Layer | | | | | Layer | | | Layer | |
| | | | Solids concentration [% by | Viscosity [mpa·s] | Average thickness [µm] | Maximum peak height [µm] | Sum of surface protrusion and depression areas [µm²] | The number of intersections | Thinnest portion thickness [µm] | Average thickness [µm] | Sum of surface protrusion and depression areas [µm²] | Thinnest portion thickness [µm] | Average thickness [µm] | Presence or absence of hard domains |
| Comparative Example 1 | 0.18 | 154 | 15.0 | 1, 704 | 5.3 | 1. 21 | 123 | 240 | 5.1 | 1.19 | 62 | 0.03 | 2.1 | None |
| Comparative Example 2 | 0.18 | 154 | 15.0 | 2,406 | 5.8 | 1. 28 | 131 | 240 | 5.6 | 1.19 | 65 | 0.03 | 2.1 | None |
| Comparative Example 3 | 0.18 | 154 | 7.0 | 177 | 5.8 | 0.77 | 78 | 240 | 5.1 | 1.19 | 39 | 0.28 | 2.1 | None |
| Comparative Example 4 | 0.18 | 154 | 15.0 | 1,103 | 4.6 | 1.17 | 119 | 240 | 4.4 | 1.19 | 60 | 0.03 | 2.1 | None |
| Comparative Example 5 | 0.18 | 154 | 15.0 | 701 | 4.5 | 1.10 | 112 | 240 | 4.3 | 1.19 | 56 | 0.09 | 2.1 | None |
| Comparative Example 6 | 0.18 | 154 | 15.0 | 301 | 4.4 | 1.01 | 103 | 240 | 4.2 | 1.19 | 51 | 0.18 | 2.1 | None |
| Comparative Example 7 | 0.18 | 154 | 15.0 | 2,005 | 5.9 | 1.24 | 127 | 240 | 5.7 | 1.19 | 63 | 0.03 | 2.1 | None |
| Comparative Example 8 | 0.18 | 154 | 15.0 | 2,406 | 11.7 | 1.15 | 117 | 240 | 11.4 | 1.19 | 59 | 0.05 | 2.1 | *None* |
| Comparative Example 9 | 0.18 | 154 | 15.0 | 2,005 | 11.8 | 1.12 | 114 | 240 | 11.5 | 1.19 | 57 | 0.07 | 2.1 | None |
| Comparative Example 10 | 0.18 | 154 | 15.0 | 1, 704 | 7.3 | 1. 15 | 117 | 240 | 7.1 | 1.24 | 59 | 0.09 | 2.1 | None |

**[Table 4]**

| No. | Dripping of primer layer-forming composition during coating | Image reproducibility [halftone dot%] | Printing unevenness | | | | Ink repellency | Printing durability [10,000 m] |
|---|---|---|---|---|---|---|---|---|
| | | | AM screen | | AM/FM mixed screen | | | |
| | | | 1 175 lpi | 2 210 lpi | 1 Equivalent to 350 lpi | 2 Equivalent to 650 lpi | | |
| Comparative Example 1 | None | 7 | Yes | Yes | Yes | Yes | 0.02 | 5.5 |
| Comparative Example 2 | None | 7 | Yes | Yes | Yes | Yes | 0.02 | 5.0 |
| Comparative Example 3 | None | 4 | None | Yes | Yes | Yes | 0.02 | 7.0 |
| Comparative Example 4 | None | 7 | Yes | Yes | Yes | Yes | 0.02 | 5.5 |
| Comparative Example 5 | None | 6 | Yes | Yes | Yes | Yes | 0.02 | 6.0 |
| Comparative Example 6 | None | 5 | None | Yes | Yes | Yes | 0.02 | 6.5 |
| Comparative Example 7 | None | 7 | Yes | Yes | Yes | Yes | 0.02 | 5.0 |
| Comparative Example 8 | None | 7 | Yes | Yes | Yes | Yes | 0.02 | 5.5 |
| Comparative Example 9 | None | 6 | Yes | Yes | Yes | Yes | 0.02 | 6.0 |
| Comparative Example 10 | None | 6 | Yes | Yes | Yes | Yes | 0.02 | 5.5 |

### DESCRIPTION OF REFERENCE NUMERALS

1: Substrate
2: Primer layer
3: Heat sensitive layer
4: Silicone rubber layer
a0: Reference height of primer layer
a1: Average thickness of primer layer
a2: Thickness of thinnest portion of primer layer
a3: Maximum peak height on surface of primer layer
a4: Portions protruding from reference height of primer layer
a5: Portions recessing from reference height of primer layer
a6: Intersection between reference height of primer layer and line representing interface between primer layer and heat sensitive layer
b0: Reference height of heat sensitive layer
b1: Average thickness of heat sensitive layer
b2: Thickness of thinnest portion of heat sensitive layer
b3: Portions protruding from reference height of heat sensitive layer
b4: Portions recessing from reference height of heat sensitive layer
c0: Reference height of substrate
c1: Portions protruding from reference height of substrate
c2: Portions recessing from reference height of substrate

## Claims

1. A directly imageable waterless planographic printing plate precursor comprising a primer layer, a heat sensitive layer and a silicone rubber layer on a substrate in this order, wherein, within a 750 µm-wide region of the primer layer in the cross-section, the sum of the total area of portions protruding from a reference height of the primer layer and the total area of portions recessing from a reference height of the primer layer is 0 to 60 µm².

2. The directly imageable waterless planographic printing plate precursor according to claim 1, wherein, within a 750 µm-wide region of the primer layer in the cross-section, the number of intersections between a reference height of the primer layer and a line representing an interface between the primer layer and the heat sensitive layer is 0 to 600.

3. A directly imageable waterless planographic printing plate precursor comprising a primer layer, a heat sensitive layer and a silicone rubber layer on a substrate in this order, wherein a maximum peak height on the surface of the primer layer is 0.5 µm or less.

4. The directly imageable waterless planographic printing plate precursor according to any one of claims 1 to 3, wherein the thinnest portion of the heat sensitive layer has a thickness of 0.2 µm or more.

5. The directly imageable waterless planographic printing plate precursor according to any one of claims 1 to 3, wherein the thinnest portion of the primer layer has a thickness of 1 µm or more.

6. The directly imageable waterless planographic printing plate precursor according to any one of claims 1 to 3, wherein, within a 750 µm-wide region of the heat sensitive layer in the cross-section, the sum of the total area of portions protruding from a reference height of the heat sensitive layer and the total area of portions recessing from a reference height of the heat sensitive layer is 0 to 30 µm².

7. The directly imageable waterless planographic printing plate precursor according to any one of claims 1 to 3, wherein the primer layer has an average thickness of 2 to 500 µm.

8. The directly imageable waterless planographic printing plate precursor according to any one of claims 1 to 3, wherein the heat sensitive layer has an average thickness of 0.5 to 2 µm.

9. The directly imageable waterless planographic printing plate precursor according to any one of claims 1 to 3, wherein the silicone rubber layer has an average thickness of 3.2 to 4.8 µm.

10. The directly imageable waterless planographic printing plate precursor according to any one of claims 1 to 3, wherein the heat sensitive layer is thermally-ablatable.

11. The directly imageable waterless planographic printing plate precursor according to any one of claims 1 to 3, wherein the silicone rubber layer contains hard domains.

12. The directly imageable waterless planographic printing plate precursor according to any one of claims 1 to 3, wherein, within a 750 µm-wide region of the substrate in the cross-section, the sum of the total area of portions protruding from a reference height of the substrate and the total area of portions recessing from a reference height of the substrate is 0 to 300 µm².

13. A method for producing the waterless planographic printing plate, which comprises an exposure step of irradiating the directly imageable waterless planographic printing plate precursor according to any one of claims 1 to 3 with laser light to form a latent image; and a development step of removing the silicone rubber layer corresponding to an image area of the latent image.

14. The method for producing a waterless planographic printing plate according to claim 13, wherein, in the exposure step of forming the latent image, an AM screen having a precision equivalent to an AM screen of 180 lpi to 650 lpi or an AM/FM mixed screen is used.
